Europäisches Patentamt

European Patent Office

Office européen des brevets

(19)

(11) **EP 1 412 552 B1**

(12) ## EUROPÄISCHE PATENTSCHRIFT

(45) Veröffentlichungstag und Bekanntmachung des Hinweises auf die Patenterteilung:
**22.12.2004 Patentblatt 2004/52**

(51) Int Cl.$^7$: **C23C 16/455**

(86) Internationale Anmeldenummer:
**PCT/CH2002/000268**

(21) Anmeldenummer: 02791430.8

(22) Anmeldetag: **15.05.2002**

(87) Internationale Veröffentlichungsnummer:
**WO 2003/012164 (13.02.2003 Gazette 2003/07)**

(54) **VERFAHREN ZUR HERSTELLUNG BESCHICHTETER SUBSTRATE**

METHOD FOR THE PRODUCTION OF COATED SUBSTRATES

PROCEDE DE FABRICATION DE SUBSTRATS DOTES D'UN REVETEMENT

(84) Benannte Vertragsstaaten:
**AT BE CH CY DE DK ES FI FR GB GR IE IT LI LU MC NL PT SE TR**

(30) Priorität: **27.07.2001 CH 141601**

(43) Veröffentlichungstag der Anmeldung:
**28.04.2004 Patentblatt 2004/18**

(73) Patentinhaber: **Unaxis Balzers Aktiengesellschaft**
**9496 Balzers (LI)**

(72) Erfinder: **RAMM, Jürgen**
**CH-9475 Sevelen (CH)**

(74) Vertreter: **Troesch, Jacques J., Dr. sc. nat.**
**Troesch Scheidegger Werner AG,**
**Schwäntenmos 14**
**8126 Zumikon (CH)**

(56) Entgegenhaltungen:
**US-A- 5 071 670** **US-A- 5 972 430**

- **KENJI HIRAMATSU ET AL: "FORMATION OF TIN FILMS WITH LOW CL CONCENTRATION BY PULSED PLASMA CHEMICAL VAPOR DEPOSITION" JOURNAL OF VACUUM SCIENCE AND TECHNOLOGY: PART A, AMERICAN INSTITUTE OF PHYSICS. NEW YORK, US, Bd. 14, Nr. 3, PART 1, 1. Mai 1996 (1996-05-01), Seiten 1037-1040, XP000620566 ISSN: 0734-2101**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren zur Herstellung materialbeaufschlagter Substrate, bei dem

a) mindestens ein Substrat in einen evakuierten Vakuumrezipienten eingeführt wird;

b) die zu beaufschlagende Oberfläche des Substrates einem Reaktivgas ausgesetzt wird, das an der Oberfläche adsorbiert wird;

c) die Aussetzung der Oberfläche an das Reaktivgas beendet wird;

d) das an der Oberfläche adsorbierte Reaktivgas reagiert wird.

Ein solches Verfahren ist aus der US 5 916 365 vorbekannt. Dabei wird ein Substrat in einen evakuierten Vakuumrezipienten eingeführt, mit einer den Prozessraum gegen die Umgebung begrenzenden Rezipientenwandung aus Keramik.

Die zu beschichtende Oberfläche des Substrates wird einem ersten Reaktivgas ausgesetzt, welches an der erwähnten Oberfläche adsorbiert wird. Durch anschliessendes Abpumpen des Reaktivgases wird die Aussetzung der Oberfläche an das Reaktivgas beendet.

Anschliessend wird ein zweites Reaktivgas eingelassen und mittels einer ausserhalb des Vakuumrezipienten vorgesehenen Spulenanordnung im Rezipienten ein elektromagnetisches Hochfrequenzfeld erzeugt. Dadurch wird mindestens ein Teil des eingelassenen zweiten Reaktivgases zu Radikalen aktiviert, und es wird das an der Oberfläche adsorbierte erste Reaktivgas ausschliesslich mit den erwähnten, durch Hochfrequenzfeld-Einwirkung generierten Radikalen reagiert.

Es ist Aufgabe der vorliegenden Erfindung, ein Verfahren eingangs genannter Art vorzuschlagen, welches vom Ablegen einer Monolage von Atomen auf der zu beschichtenden Oberfläche des Substrates ausgeht, dabei aber eine wesentlich erweiterte Einsatzflexibilität hat mit Bezug auf die Vielfalt ablegbarer Monolagen.

Dabei sprechen wir von Materialbeaufschlagung deshalb, weil die erwähnte Monolage nicht als geschlossene Lage im Sinne einer Schicht abgelegt werden muss, sondern die Dichte abgelegter Atome weit geringer sein kann, als dies für die Bildung einer geschlossenen Lage notwendig ist. Sehr wohl kann aber, falls erwünscht, die Materialbeaufschlagung so erfolgen, dass eine geschlossene Monolage gebildet wird, dann im Sinne einer Schicht.

Dies wird erfindungsgemäss dadurch erreicht, dass

$d_1$) die Oberfläche mit dem adsorbierten Reaktivgas einer niederenergetischen Plasmaentladung mit Ionenenergie $E_{Io}$ an der Oberfläche des Substrates von

$$0 < E_{Io} \leq 20 \text{ eV}$$

und einer Elektronenenergie $E_{eo}$ von

$$0 \text{ eV} < E_{eo} \leq 100 \text{ eV}$$

ausgesetzt wird.

$d_2$) das adsorbierte Reaktivgas mindestens unter Mitwirkung plasmaerzeugter Ionen und Elektronen reagiert wird.

Im Unterschied zur erwähnten US 5 916 365, wo das adsorbierte Gas ausschliesslich durch per Definition elektrisch neutrale Radikale reagiert wird, wird erfindungsgemäss das an der Oberfläche adsorbierte Reaktivgas jedenfalls auch durch Einwirkung niederenergetischer Plasmaentladung-erzeugter Ionen und Elektronen sanft reagiert. Damit ist die Möglichkeit gegeben, das adsorbierte Gas auch ohne Einwirkung von Radikalen eines weiteren Reaktivgases an der Oberfläche eigentlich zu stabilisieren, lediglich durch "sanfte" Wechselwirkung mit niederenergetischen Edelgasionen und Elektronen oder durch ebensolche Einwirkung von anderen Reaktivgasionen.

Obwohl in der erwähnten US 5 916 365 ausgeführt ist, es sei vorbekannt gewesen, dünne Schichten unter Beizug einer Glimmentladung in einer Reaktivgasmischungsatmosphäre abzulegen, was aber nicht zu zufriedenstelllender Schichtbildung geführt hätte, wird im Zuge der vorliegenden Beschreibung erläutert werden, wie die erfindungsgemäss eingesetzte Plasmaentladung gestaltet werden muss, um, zusätzlich zur Erzeugung der Wirkung von Ionen und Elektronen auf das adsorbierte Reaktivgas oder - gasgemisch, in der Plasmaentladung auch ein zweites Reaktivgas bzw. Reaktivgasgemisch zu Radikalen und Ionen zu aktivieren und das adsorbierte Reaktivgas oder -gasgemisch zusätzlich mit durch Plasmaaktivierung erzeugten, an sich elektrisch neutralen Radikalen sowie Reaktivgasionen in Wechselwirkung zu bringen.

Weil nun jedenfalls elektrisch geladene Teilchen an der Reaktion des adsorbierten Gases beteiligt sind, lässt sich die Reaktion und insbesondere auch deren Verteilung durch elektrische und/oder magnetische Felder steuern, wodurch aber das Verhalten von Radikalen allein nicht beeinflusst würde.

In einer bevorzugten Ausführungsform wird die Ionenenergie $E_I$ an der Oberfläche des Substrates weiter auf den Bereich

$$0 \text{ eV} < E_I \leq 15 \text{ eV}$$

reduziert. Im weiteren kann das adsorbierte Reaktivgas durchaus auch ein Reaktivgasgemisch sein. Die Plasmaentladung wird im weiteren entweder in einer Edelgasatmosphäre unterhalten, dabei bevorzugterweise in einer Argonatmosphäre, oder es wird die Plasmaentladung in einer Atmosphäre erzeugt, welche ein weiteres Reaktivgas oder -gasgemisch enthält. Dabei enthält bevorzugterweise dieses weitere Reaktivgas oder -gasgemisch mindestens eines folgender Gase:

Wasserstoff, Stickstoff, Sauerstoff, bevorzugterweise Wasserstoff, oder es besteht aus Wasserstoffgas.

In einer weiteren bevorzugten Ausführungsform des erfindungsgemässen Verfahrens wird der Vakuumrezipient auf einen Druck $p_v$ evakuiert, für den gilt:

$$10^{-11} \text{ mbar} \leq p_v \leq 10^{-8} \text{ mbar.}$$

Dadurch wird sichergestellt, dass sich praktisch keine Kontaminationssubstanzen aus der Vakuumatmosphäre, in welche das Substrat eingeführt wird, störend auf die Oberfläche ablegen.

Das Reaktivgas oder -gasgemisch, welches an der Oberfläche adsorbiert werden soll, wird in einer weiteren bevorzugten Ausführungsform bis zu einem Partialdruck $p_p$ eingelassen, für welchen gilt:

$$10^{-4} \text{ mbar} \leq p_p \leq 1 \text{ mbar.}$$

Bis zu einem gewissen Grade kann die Menge an der Oberfläche adsorbierten Reaktivgases oder -gasgemisches gesteuert werden durch die Zeitspanne zwischen Aussetzen der erwähnten Oberfläche und Beendigung dieser Aussetzung. Dabei kann im wesentlichen von einer gegen einen Sättigungswert hin laufenden Exponentialfunktion ausgegangen werden, mit einer für die Dynamik der Absättigung kennzeichnenden Zeitkonstanten. Diese Zeitkonstante kann dabei erforderlichenfalls durch Beheizen bzw. Kühlen der Oberfläche gesteuert werden.

In einer weiteren bevorzugten Ausführungsform des erfindungsgemässen Verfahrens wird die Aussetzung der Oberfläche an das zu adsorbierende Reaktivgas oder Reaktivgasgemisch dadurch beendet, dass man das Substrat aus dem evakuierten Vakuumrezipienten mit dem Reaktivgas oder -gasgemisch in einen weiteren evakuierten Vakuumrezipienten überführt. Im weiteren evakuierten Vakuumrezipienten werden die verbleibenden Verfahrensschritte vollzogen. Dies hat den Vorteil, dass ein erster Vakuumrezipient ausschliesslich der Gasadsorption dient und damit kontaminationsfrei bleibt, während der weitere Vakuumrezipient für die Plasmaentladungs-Reaktion des adsorbierten Gases eingesetzt wird.

Bei diesem Vorgehen ist es beispielsweise möglich, zentral einen weiteren Vakuumrezipienten vorzusehen für die Plasmaentladungs-Weiterbehandlung der Substrate, welche vorgängig ggf. unterschiedliche Reaktivgase oder Reaktivgasgemische adsorbiert haben, in um den zentralen, weiteren Vakuumrezipienten herum gruppierten, spezifischen "Adsorptions"-Rezipienten. Damit können komplexe, aus einer Vielzahl auch unterschiedlicher Atommonolagen bestehende Schichtsysteme Lage um Lage aufgebaut werden.

Dabei kann in vielen Fällen für das sequentielle Ablegen unterschiedlicher oder gleicher atomarer Monolagen im zentralen Plasma-Reaktionsrezipienten unter Einsatz der erwähnten niederenergetischen Entladung dasselbe zweite Reaktivgas oder Reaktivgasgemisch eingesetzt werden, nämlich insbesondere bevorzugt Stickstoff und/oder Wasserstoff und/oder Sauerstoff, dabei insbesondere bevorzugt Wasserstoff. Auch können, umgekehrt, mehrere der weiteren Vakuumrezipienten für die Reaktion der adsorbierten Reaktivgase oder -gasmischungen in Plasmen einem "Adsorptions"-Rezipienten zugeordnet werden, nämlich vor allem dann, wenn der Adsorptions-Schritt zeitlich kürzer ist als der Reaktions-Schritt in Plasma.

In einer weiteren bevorzugten Ausführungsform des erfindungsgemässen Verfahrens wird das Aussetzen der Oberfläche an das zu adsorbierende Reaktivgas oder Reaktivgasgemisch durch Abpumpen des verbleibenden Reaktivgases oder -gasgemisches aus dem evakuierten Vakuumrezipienten beendet.

Dabei wird bevorzugterweise dieses Abpumpen bis zum Erreichen eines Totaldruckes $p_v'$ im Vakuumrezipienten vorgenommen, für welchen gilt:

$$10^{-11} \text{ mbar} \leq p_v' \leq 10^{-8} \text{ mbar.}$$

Mit andern Worten werden bei der Beendigung der Reaktivgas-Aussetzung die gleichen Druckverhältnisse wieder eingestellt, die vor der Gasaussetzung vorherrschten, d.h. Ultrahochvakuum-Verhältnisse.

Wird, wie vorgängig erwähnt, die Beendigung des Adsorptionsschrittes dadurch realisiert, dass das Substrat in einen weiteren Vakuumrezipienten übergeführt wird, so werden dort, abgesehen vom Edelgas-Partialdruck und/oder Partialdruck eines zweiten Reaktivgases oder -gasgemisches, ebenfalls die erwähnten Restgas-Ultrahochvakuum-Druckverhältnisse eingestellt.

Das Reagieren des adsorbierten Reaktivgases oder - gasgemisches unter Mitwirkung plasmaerzeugter Ionen und Elektronen ist nicht zeitkritisch, aufgrund des Einsatzes des niederenergetischen Plasmas erwähnter Art. Dieser Prozess läuft, mindestens genähert, wiederum exponentiell an einem Asymptotenwert. Wird die Plasmabehandlung mindestens während einer vorgegebenen Minimalzeitspanne aufrechterhalten, so kann danach diese Behandlung weiter aufrecht erhalten bleiben, ohne die entstandene dann geschlossene Atom-Monolage wesentlich zu beeinträchtigen. Dies hat für die Automatisierung und das Takten des erfindungsgemässen Verfahrens, z.B. eingebettet in eine komplexe Abfolge zusätzlicher Oberflächenbehandlungsschritte, wesentliche Vorteile.

Bricht man das erfindungsgemässe Verfahren nach dem Verfahrensschritt $d_2$) ab, so entsteht je nach Adsorptionsmenge (Aussetzungszeit-gesteuert) und/oder Menge der zur Adsorption zur Verfügung stehenden Gasatome sowie Plasmaeinwirkung (Plasmabehandlungs-Zeit und/oder -Intensität) und/oder der Ausnützung eines zweiten Reaktivgases oder -gasgemisches (Radikalen- und Ionen-Bildung) eine unterschiedlich dichte Atom-Monolage bis hin zu einer geschlossen Atom-Monolage. Wird keine geschlossene Atom-Monolage angestrebt, so ist die Möglichkeit gegeben, praktisch im Sinne einer Implantierungs- oder Impfungs-Technik auf die Substratoberfläche oder eine bereits abgelegte geschlossene Atom-Monolage nur "vereinzelte" Atome gleicher Art wie die der Unterlage oder anderer Art bzw. anderen Materials abzulegen.

In einer weiteren bevorzugten Ausführungsform dieses Verfahrens werden mindestens die Verfahrensschritte b) bis $d_2$) mindestens zweimal durchlaufen, wodurch mindestens zwei atomare Monolagen übereinander abgelegt werden. Dabei können von Monolage zu Monolage die Oberflächenadsorbierten Reaktivgase bzw. -gasgemische geändert werden, ebenso ggf. zweite eingesetzte Reaktivgase oder -gasgemische in der Plasmaentladungsatmosphäre, so dass als Monolagen gezielt unterschiedliche Lagen abgelegt werden können. Wird dabei eine epitaktische Schicht angestrebt, entsteht eine hetero-epitaktische Schicht. Wird in allen Lagen dasselbe Material abgelegt, entsteht bei epitaktischem Aufwachsen, Homoepitaxie.

Im weiteren ist es aber ganz grundsätzlich möglich, in einer bevorzugten Ausführungsform, nach mindestens einmaliger Durchführung des Schrittes $d_2$), sei dies somit zum ersten Mal, oder, bei mehrmaligem - n - Durchlaufen der Zyklen b) bis $d_2$), ein weiteres Material auf die dann resultierende Oberfläche aufzubringen, und zwar mit irgend einem der bekannten Beschichtungsverfahren, seien diese vakuumtechnisch, nasschemisch bzw. galvanisch.

In einer weiteren, besonders bevorzugten Ausführungsform des erfindungsgemässen Verfahrens wird, bevor die erwähnte Oberfläche dem zu adsorbierenden Reaktivgas oder Reaktivgasgemisch ausgesetzt wird, diese Oberfläche einem niederenergetischen Edelgasplasma, vorzugsweise Argonplasma, ausgesetzt, mit einer Ionenenergie an der erwähnten Oberfläche, für welche gilt:

$$0\ eV < E_{I1} \leq 20\ eV$$

vorzugsweise gar von

$$0\ eV < E_{I1} \leq 15\ eV$$

und bei Elektronenenergien $E_{e1}$ von

$$0\ eV\ 0 < E_{e1} \leq 100\ eV.$$

Dadurch werden an der nachmals gasadsorbierenden Oberfläche definierte Oberflächenzustände geschaffen.

In einer weiteren bevorzugten Ausführungsform des erfindungsegmässen Verfahrens wird vor dem Aussetzen der erwähnten Oberfläche dem zu adsorbierenden Reaktivgas oder Reaktivgasgemisch die Oberfläche einer niederenergetischen Plasmaentladung in einer Atmosphäre, die ein weiteres Reaktivgas enthält, ausgesetzt, wobei für die Ionenenergie $E_{I2}$ an der Substratoberfläche gilt:

$$0\ eV < E_{I2} \leq 20\ eV,$$

vorzugsweise gilt

$$0\ eV < E_{I2} \leq 15\ eV$$

bei einer Elektronenenergie $E_{e2}$ von

$$0\ eV < E_{e2} \leq 100\ eV.$$

Auch hier werden einerseits definierte Oberflächenzustände an der nachmals gasadsorbierenden Oberfläche geschaffen, und zudem wird die erwähnte Oberfläche gereinigt. Dies insbesondere beim bevorzugten Einsatz, als weiteres Reaktivgas, mindestens eines der Gase Wasserstoff, Stickstoff oder Sauerstoff. Besondere bevorzugt wird dabei der Einsatz einer Wasserstoff enthaltenden Atmosphäre, vorzugsweise einer Atmosphäre, die ggf. neben einem Edelgas, wie insbesondere Argon, aus Wasserstoff besteht.

Es seien nun bevorzugterweise nach der Gasadsorption und dem Reagieren des adsorbierten Gase vorgenommene Verfahrensschritte betrachtet.

Dabei wird in einer besonders bevorzugten Ausführungsform nach dem Reagieren des adsorbierten Reaktivgases oder - gemisches, die Oberfläche einem niederenergetischen Edelgasplasma, vorzugsweise Argonplasma, ausgesetzt, mit einer Ionenenergie $E_{I3}$ an der Oberfläche von

$$0 \text{ eV} < E_{I3} \leq 20 \text{ eV},$$

vorzugsweise von

$$0 \text{ eV} < E_{I3} \leq 15 \text{ eV}$$

und mit einer Elektronenenergie $E_{e3}$ von

$$0 \text{ eV} < E_{e3} \leq 100 \text{ eV}.$$

In einer weiteren bevorzugten Ausführungsform des erfindungsgemässen Verfahrens wird nach dem erwähnten Reagieren des adsorbierten Reaktivgases, die Oberfläche einer niederenergetischen Plasmaentladung in einer Atmosphäre, die ein weiteres Reaktivgas oder Reaktivgasgemisch enthält, ausgesetzt, wobei für die Ionenenergie $E_{I4}$ an der Substratoberfläche gilt:

$$0 \text{ eV} < E_{I4} \leq 20 \text{ eV},$$

vorzugsweise

$$0 \text{ eV} < E_{I4} \leq 15 \text{ eV}$$

und mit Elektronenenergie $E_{e4}$, für welche gilt

$$0 \text{ eV} < E_{e4} \leq 100 \text{ eV}.$$

Auch hier wird bevorzugterweise als weiteres Reaktivgas mindestens eines der Gase Wasserstoff, Stickstoff, Sauerstoff eingesetzt, dabei insbesondere unter Verwendung von Wasserstoff.

Dabei werden durch Reagieren dieses weiteren Reaktivgases gleichzeitig auch die Innenflächen des Vakuumrezipienten gereinigt.

Wenn, wie oben erläutert wurde, auch für das Reagieren des adsorbierten Reaktivgases die Plasmaentladung in einem Reaktivgas oder Reaktivgasgemisch unterhalten wird, insbesondere mit mindestens einem der Gase Wasserstoff, Stickstoff oder Sauerstoff, ganz besonders bevorzugt mit mindestens dominantem Wasserstoffanteil, so werden auch dann gleichzeitig die Innenflächen des Vakuumrezipienten gereinigt, und zwar schneller, sauberer und definierter, als dies allein durch Abpumpen möglich wäre.

Insbesondere durch Wahl des der Reaktivgasadsorption vorangehenden Plasmabehandlungsverfahrens wird der Zustand der nachmals gasadsorbierenden Oberfläche mindestens mitbeeinflusst. Damit wird auch beeinflusst, ob sich eine epitaktische Ablagerung ergeben wird, oder eine amorphe oder polykristalline, bei ungereinigter, amorpher, polykristalliner Substratoberfläche. Auch durch die Substratoberflächen-Temperatur kann die diesbezügliche Aufwachscharakteristik beeinflusst werden.

Mit dem erfindungsgemässen Verfahren zur Herstellung materialbeaufschlagter Substrate erfolgt in besonders bevorzugter Art und Weise die Beaufschlagung mittels mindestens einem der folgenden Materialien:

Oxide oder Nitride oder Oxinitride von Si, Ge, Ti, Ta, Hf, Zr, Al, Nb, W und/oder der folgenden Metalle:

Al, Ti, Cu, W, Ta, oder Mischungen der erwähnten Materialien. Besonders bevorzugt erfolgt die erwähnte Oberflächenbeaufschlagung mit mindestens einem der Materialien:

Siliziumoxid, Tantaloxid, Zirkonoxid, Titannitrid, Tantalnitrid, Wolframnitrid, $(Ta\text{-}Si)_x N_y$.

In einer weiteren, weitaus bevorzugten Ausführungsform des erfindungsgemässen Verfahrens wird die die Oberfläche des Substrates umgebende Prozessatmosphäre während mindestens einer der Phasen, bestehend aus den Schritten b) und c) und/oder d) bis $d_2$), von der Innenwand eines an Umgebung liegenden Vakuumrezipienten getrennt. Mithin wird diese Trennung entweder während die zu beschichtende Oberfläche dem Reaktivgas oder -gasgemisch zur Absorption ausgesetzt ist vorgenommen - bis zur Beendigung dieser Aussetzung - und/oder während des Reagierens des adsorbierten Gases.

Die grundsätzliche Erkenntnis ist dabei, dass eine funktionale Trennung von Strukturen, welche gegenüber Umgebungsdruck die erforderlichen vakuumtechnischen Druckverhältnisse sicherstellen, einerseits, und von Strukturen, die dem Behandlungsprozess direkt ausgesetzt sind, anderseits, mit Blick auf die hohen Reinheitsanforderungen und/oder optimale Integrierbarkeit des erfindungsgemässen Verfahrens in einen automatisierten Fertigungsablauf, wesentliche Vorteile mit sich bringt.

Wenn von der zu beaufschlagenden Oberfläche eines Substrates gesprochen wird und wurde, so ist darunter auch die Oberfläche eines bereits beaufschlagten oder beschichteten Substrates zu verstehen. Es sei folgendes Beispiel vor Augen geführt, für welches sich das erfindungsgemässe Verfahren besonders eignet:

Ein Substrat sei mit einer dielektrischen, insbesondere $SiO_2$-Schicht beschichtet. Durch hier nicht weiter interessierende Ätzschritte sind Kanäle mit einem Tiefenzu-Breiten-Verhältnis von z.B. 1:10, beispielsweise mit einer Breite von 50 nm, in die Schicht aus dem erwähnten dielektrischen Material eingelassen. Diese Kanäle sollen mit einem elektrisch leitenden Material, insbesondere mit Kupfer, zur Bildung sogenannter "interconnects" beispielsweise galvanisch gefüllt werden. Das Ablegen insbesondere von Kupfer auf dielektrischen Oberflächen ist, was die Haftung abgelangt, höchst problematisch. Nun wird erfindungsgemäss auf die Oberfläche der dielektrischen Schicht, inklusive der Kanäle, ein nur wenig Atom-Monolagen umfassender Liner abgelegt, als Haftvermittlungsschicht zwischen dem dielektrischen Material und dem elektrisch leitenden Material. Aufgrund ihrer extrem kleinen Dicke beeinträchtigt sie den Leiterquerschnitt der erwähnten Interconnect-Kanäle nur vernachlässigbar. Solche Haftvermittlungsschichten sind als Liner-Schichten oder "seed-layers" bekannt.

In einer weiteren bevorzugten Ausführungsform des erfindungsgemässen Verfahrens wird die Substratoberfläche (ggf. umfassend die Substratbeschichtungsoberfläche) vor dem Absorptionsschritt und/oder nach dem Reagieren des adsorbierten Reaktivgases oder -gasgemisches, durch Einsatz eines plasmaunterstützten Reinigungsschrittes gereinigt, bei dem in einen Reinigungs-Prozessraum eingelassenes Reaktivgas oder -gasgemisch - vorzugsweise Wasserstoff mindestens enthaltend - mittels einer niederenergetischen Plasmaentladung mit einer Ionenenergie Er an der Substratoberfläche von

$$0 \text{ eV} < E_r \leq 20 \text{ eV}$$

vorzugsweise

$$0 \text{ eV} < E_r \leq 15 \text{ eV}$$

aktiviert wird, bei einer Elektronenenergie $E_{er}$ von

$$0 \text{ eV} < E_{er} \leq 100 \text{ eV}.$$

In einer bevorzugten Ausführungsform, diesen mindestens einen Reinigungsschritt umfassenden, erfindungsgemässen Verfahrens wird während des Reinigungsschrittes die Reinigungsprozessatmosphäre mittels einer metallischen Umkapselung von der Innenwandung eines an Umgebung liegenden Reinigungsvakuumsrezipienten abgetrennt, oder - und dies bevorzugt - es wird diese Prozessatmosphäre direkt durch die Innenwandung des an Umgebung liegenden Reinigungsvakuumrezipienten begrenzt.

Berücksichtigt man, dass, wie noch zu erwähnen sein wird, bevorzugterweise die erfindungsgemäss eingesetzten Verfahrensphasen aus den Schritten b) und c) einerseits und/oder d) bis $d_2$) in einer Prozessatmosphäre durchgeführt werden, die durch dielektrisches Material von der üblicherweise metallischen Wandung getrennt ist, welche an Umgebungsdruck liegt, so ist ersichtlich, dass durch letzterwähntes Vorgehen, für die erwähnten Reinigungsschritte, kostengünstigere Lösungen eingesetzt werden. Dabei ist zu beachten, dass insbesondere ein Reinigungsschritt vor dem erstmaligen Aussetzen der Substratoberflächen an zu adsorbierendes Reaktivgas oder Reaktivgasgemisch zu einer namhaften Rezipientenwandungs-Kontamination führen kann.

Wie bereits angetönt, wird in einer bevorzugten Ausführungsform durch eine einzige Abfolge der Schritte a) bis $d_2$) eine einzige Atom-Monolage auf die Oberfläche abgelegt, ggf. mit gezielt eingestellter Dichte bis hin zu einer geschlossenen Lage. In einer weiteren bevorzugten Ausführungsform wird durch Wiederholen der Schritte b) bis $d_2$) eine mehrlagige, z.B. epitaktische Schicht aufgewachsen. Wird dabei jeweils dasselbe zu adsorbierende Reaktivgas oder Reaktivgasgemisch eingesetzt, führt dies - bei einkristalliner, gereinigter Oberfläche - bei epitaktischem Wachstum, zu einer homoepitaktischen Schicht, wird das zu adsorbierende Reaktivgas jeweils gewechselt nach einer vorgegebenen Anzahl abgelegter Monolagen, so führt dies zu äusserst dünnen heteroepitaktischen Schichten.

In einer weiteren bevorzugten Ausführungsform des erfindungsgemässen Verfahrens wird nach Durchführung einer vorgegebenen Anzahl Durchläufe der Schritte b) bis $d_2$), insbesondere sequentiell an mehreren Substraten, der Prozessraum des Vakuumrezipienten einem plasmaunterstützten Prozessraum-Reinigungsschritt ohne eingeführtes Substrat unterzogen oder ggf. mit einer Substrat-Attrappe im Vakuumrezipienten, welcher Prozessraumreinigungsschritt bevorzugt erst einen Ätzschritt umfasst, danach einen Reinigungsschritt, bevorzugt in einem Plasma mit Wasserstoff, einem Edelgas oder einer Mischung daraus.

In einer weiteren bevorzugten Ausführungsform des erfindungsgemässen Verfahrens führt man vor Schritt a) und/oder nach Schritt $d_2$), örtlich vom erwähnten Vakuumrezipienten getrennt, einen Substratreinigungsschritt durch, wobei man den Transport des Substrates zwischen dem erwähnten Vakuumrezipienten und einem Reinigungsrezipienten in Vakuum durchführt.

Bevorzugt wird dabei dieser Transport, mindestens stückweise, linear realisiert oder - und dies besonders bevorzugt - entlang einer Kreisbahn mit linearen Zuführbewegungen zu den erwähnten Rezipienten, vorzugsweise mit bezüglich der Kreisbahn radialer Bewegungskomponente.

In einer weiteren bevorzugten Ausführungsform des erfindungsgemässen Verfahrens wird die Prozessatmosphäre während der Phasen mit den Schritten b) und c) und/oder d) bis $d_2$) von der Innenwandung eines an Umgebung liegenden Vakuumrezipienten getrennt, und zwar mittels einer im Neuzustand chemisch gegen das zu adsorbierende Reaktivgas oder -gasgemisch und/oder gegen ein zweites, plasmaaktiviertes Reaktivgas oder -gasgemisch inerten Oberfläche, vorzugsweise mittels einer dielektrischen oder graphitischen Oberfläche.

Dabei wird in einer weiter bevorzugten Ausführungsform die inerte Oberfläche als Oberfläche einer Trennwand ausgelegt, die entlang überwiegender Flächenabschnitte von der Innenwandung des Vakuumrezipienten beabstandet ist. Es wird bevorzugt die Oberfläche zur Trennung, im Neuzustand, aus mindestens einem der folgenden Materialien realisiert:

Quarz, Graphit, Siliziumkarbid, Siliziumnitrid, Aluminiumoxid, Titanoxid, Tantaloxid, Nioboxid, Zirkonoxid oder einer geschichteten Kombination dieser Materialien, dann auch mit diamantähnlichem Kohlenstoff oder Diamant.

In einer weiteren, höchst bevorzugten Ausführungsform des erfindungsgemässen Verfahrens wird die Plasmaentladung mit einer Elektronenquelle mit Elektronenenergie ≤ 50 eV, insbesondere dabei bevorzugt mittels einer DC-Entladung realisiert.

Bevorzugt wird dies weiter mittels einer thermionischen Kathode erreicht, bevorzugt mittels einer direkt beheizten, thermionischen Kathode.

Dadurch, dass man im Prozessraum des Vakuumrezipienten für die erwähnte Plasmaentladung bevorzugt mindestens zwei örtlich versetzte und vorzugsweise je beheizbare Anoden vorsieht, vorzugsweise je getrennt elektrisch betätigbar, und die je daran angelegten elektrischen Potentiale und/oder die Anoden-Temperaturen steuert bzw. stellt, wird die Plasmadichteverteilung entlang der Oberfläche statisch oder dynamisch eingestellt oder gesteuert. Dabei wird in einer weiter bevorzugten Ausführungsform die Kathoden-Anodenstrecke für die Plasmaentladung im wesentlichen senkrecht und bevorzugt zentrisch zur erwähnten Oberfläche angeordnet.

In einer weiteren bevorzugten Ausführungsform des erfindungsgemässen Verfahrens wird im Prozessraum während der Erzeugung der Plasmaentladung ein Magnetfeld erzeugt und mittels dieses Feldes stationär und/oder dynamisch die Plasmadichteverteilung entlang der Oberfläche eingestellt oder gesteuert. Vorzugweise wird dabei die Plasmadichteverteilung mindestens örtlich gewobbelt, mit dem Effekt, wie wenn das stationär im Plasma gehaltene Substrat sich bezüglich der Entladung bewegte.

Im weiteren wird bevorzugt mindestens das zu adsorbierende Reaktivgas oder -gasgemisch in den Prozessraum verteilt eingelassen, bevorzugt mit einer Einströmrichtung im wesentlichen parallel zur Substratoberfläche und, weiter bevorzugt, mit von der Substratoberfläche äquidistanten Eindüsungsstellen. In einer ganz besonders bevorzugten Ausführungsform des erwähnten Verfahrens ist das Substrat gebildet durch ein Siliziumoxid-beschichtetes Substrat mit in die Siliziumschicht eingelassenen Kanälen, wobei man nach n-maligem Durchführen des Schrittes $d_2$) in die Kanäle Kupfer ablegt. Dabei ist n jedenfalls grösser als 1.

Die Erfindung wird nun anhand von Figuren erläutert. Es zeigen:

Fig. 1    schematisch, eine erste Ausführungsvariante eines Prozessmoduls zur Durchführung des erfindungsgemässen Verfahrens, insbesondere dessen Phasen $Ph_1$ und/oder $Ph_2$;

Fig. 2    in Darstellung analog zu derjenigen von Fig. 1, eine bevorzugte Ausführungsvariante des Prozessmoduls gemäss Fig. 1;

Fig. 3    in einer Darstellung analog zu den Fig. 1 bzw. 2, ein weiterer Prozessmodultyp zur Durchführung von Reinigungsschritten am erfindungsgemässen Verfahren;

Fig. 4    in Darstellung analog zu den Fig. 1 bis 3, eine Abwandlung des in Fig. 3 dargestellten Prozessmoduls;

Fig. 5    vereinfacht, eine bevorzugte Ausführungsform eines Prozessmoduls gemäss Fig. 2, wandelbar in ein Prozessmodul gemäss Fig. 3 oder 4;

Fig. 6    mit Bezug auf eine Blendenachse A des Prozessmoduls gemäss Fig. 5, die durch Steuerung bewirkte örtliche und zeitliche Modulation zur Achse A paralleler Magnetfeldkomponenten über einer Ebene E, senkrecht zur Blendenachse A;

Fig. 7    beispielsweise und schematisch ein erfindungsgemässes Verfahren für Mehrlagen-Realisation;

Fig. 8    eine weitere Ausführungsform eines erfindungsgemässen Verfahrens bei Mehrlagen-Realisation, und

Fig. 9    in Aufsicht und vereinfacht, die Kombination von Prozessmodulen gemäss den Fig. 1 bis 5 zu einer Zirkulär- bzw. Cluster-Anlage, für die Durchführung des erfindungsgemässen Verfahrens.

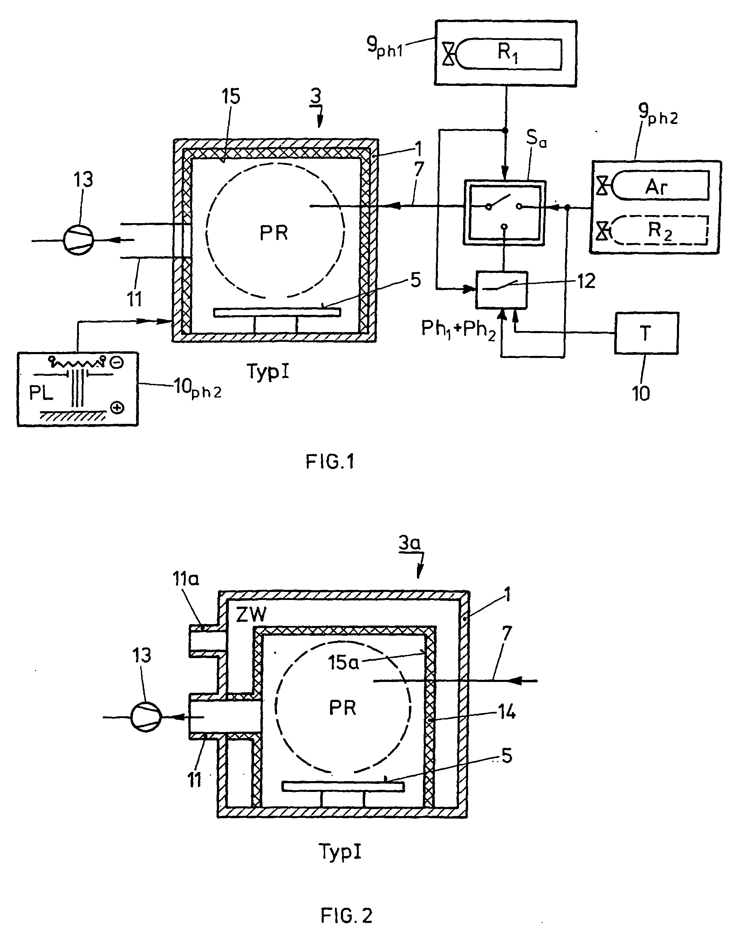

In Fig. 1 ist schematisch ein bevorzugterweise für die Durchführung des erfindungsgemässen Verfahrens eingesetztes Prozessmodul des Typs I dargestellt. Eine Kammerwand 1 eines Vakuumrezipienten 3 umschliesst einen Prozessraum PR. Im Prozessraum PR ist ein Substratträger 5 vorgesehen. Der Prozessraum PR wird über einen Pumpanschluss 11, wie schematisch mit der Vakuumpumpe 13 dargestellt, auf den zur Durchführung des erfindungsgemässen Herstellungsverfahrens geforderten Druck $p_v$ von

$$10^{-11} \text{ mbar} \leq p_v \leq 10^{-8} \text{ mbar}$$

abgepumpt. Der Aufbau des Rezipienten genügt UHV-Bedingungen (z.B. metallisch gedichteter Vakuumkessel, ausheizbar). Der weitaus überwiegende Oberflächenbereich der dem Prozessraum PR zugewandten Oberfläche der Kammerwand 1, welche üblicherweise aus rostfreiem Stahl bzw. Inox besteht, ist aus einem wie noch zu erläutern sein wird inerten Material gefertigt. Gemäss der in Fig. 1 dargestellten Ausführungsform des Typ I Prozessmoduls ist hierzu die Kammerwand 1 mit dem erwähnten inerten Material innenbeschichtet, oder es sind an der Kammerwand 1 innen Wandungspartien mindestens mit Innenoberflächen aus dem erwähnten inerten Material montiert. Diese Beschichtung bzw. diese Inertmaterialoberflächen sind in Fig. 1 mit 15 bezeichnet.

Wie eingangs erläutert umfasst der erfindungsgemässe Herstellungsprozess zwei an sich nicht zwingend im gleichen Vakuumrezipienten durchzuführende Phasen, nämlich

- **Phase 1, Ph$_1$:** Aussetzen der Substratoberfläche einem zu adsorbierenden Reaktivgas oder Reaktivgasgemisch bis zur Beendigung dieser Aussetzung,

- **Phase 2, Ph$_2$:** Aussetzen der Substratoberfläche einer niederenergetischen Plasmaentladung und damit Reagieren des adsorbierten Reaktivgases.

Dabei kann bei Ausbildung der Plasmaentladung in Ph$_2$ als niederenergetische Plasmaentladung mit Ionenenergien E wie eingangs spezifiziert die Atmosphäre, worin die Plasmaentladung unterhalten wird, ein zweites Reaktivgas bzw. Reaktivgasgemisch enthalten, insbesondere bevorzugt Wasserstoff und/oder Stickstoff und/oder Sauerstoff.

Das in Fig. 1 dargestellte Typ I Prozessmodul eignet sich hervorragend für die Durchführung der Phase Ph$_1$ und/oder Ph$_2$. Gemäss Fig. 1 führt - wie schematisch dargestellt - eine Gaszuführung 7 in den Prozessraum PR des Vakuumrezipienten 3. Wie mit dem Auswahlschalter S$_a$ schematisiert, ist die Zuführleitung 7 allein für die Durchführung der Phase Ph$_1$ im Rezipienten 3, mit einer Gastankanordnung 9$_{ph1}$ verbunden, welche das von der Substratoberfläche zu adsorbierende Reaktivgas oder Reaktivgasgemisch R$_1$ enthält.

Wird hingegen der Vakuumrezipient 3 ausschliesslich für die Durchführung der Phase Ph$_2$ eingesetzt, so wird die Zuführleitung 7 mit einer Gastankanordnung 9$_{ph2}$ verbunden, welche einerseits ein Edelgas, vorzugsweise Argon Ar, enthält und/oder - wie gestrichelt angedeutet - ein zweites Reaktivgas R$_2$, vorzugsweise Wasserstoff, Sauerstoff und/oder Stickstoff.

Wird im Vakuumrezipienten 3 sowohl Phase Ph$_1$ wie auch Phase Ph$_2$ durchgeführt, dann werden, wie mit der Zeitsteuereinheit 10 und dem Umschalter 12 in Fig. 1 dargestellt, in vorgegebener zeitlicher Abfolge sowohl Gastank 9$_{ph1}$ wie auch 9$_{ph2}$ auf die Zuführleitung 7 geschaltet.

Im weiteren wird im Vakuumrezipienten 3, wie im Block 10$_{ph2}$ dargestellt, eine Plasmaentladungsstrecke PL, nämlich eine niederenergetische Plasmaentladungsstrecke, vorgesehen, sofern in Alleinstellung Ph$_2$ oder kombiniert mit Ph$_1$ im Vakuumrezipienten 3 durchgeführt wird. Es sei auf die Darstellung in Fig. 1 hingewiesen, wonach der Doppelpfeil zum Block 10$_{ph2}$ die Integrierung der Plasmaentladungsstrecke in den Rezipienten 3 bedeutet und Block S$_a$ in Doppellinien-Darstellung, dass dieser Block schematisch Alternativen bei der Realisation des Typ I Proessmoduls darstellt.

In Phase Ph$_1$ wird, nachdem ein Substrat auf dem Substratträger 5 abgelegt worden ist, über die Zuführleitung 7 das Reaktivgas bzw. Reaktivgasgemisch R$_1$ eingelassen und von der Oberfläche des Substrates adsorbiert. Danach wird das Substrat der Phase Ph$_2$ zugeführt, sei dies im selben Rezipienten 3 oder einem entsprechend ausgebildeten, weiteren Rezipienten 3. Zur Beendigung des Adsorptionsvorganges ist jedenfalls der für beide Phasen verwendete Rezipient 3 wiederum auf die angegebenen Ultrahochvakuum-Bedingungen abgepumpt, oder es ist der weitere Rezipient, der auf dieses Ultrahochvakuum abgepumpt ist oder wird, bevor das Substrat mit adsorbiertem Gas eingeführt wird. Danach wird Edelgas, vorzugsweise Argon Ar, eingelassen und/oder das weitere Reaktivgas und die niederenergetische Plasmaentladung, dabei insbesondere bevorzugt eine DC-Entladung, erstellt. Bei der DC-Entladung wird weiter bevorzugt eine unselbständige Entladung eingesetzt, bevorzugt mit einer thermionischen Kathode, vorzugsweise einer direkt beheizten thermionischen Kathode.

Durch gezielte Steuerung der Zeitspanne, während welcher das Substrat dem Reaktivgas R$_1$ bzw. dem Reaktivgasgemisch in Phase Ph$_1$ ausgesetzt ist, und/oder seiner Oberflächenbeschaffenheit und/oder der zugeführten Reaktivgas- bzw. Reaktivgasgemisch-Menge, kann gezielt der Belegungsgrad der Oberfläche des Substrates mit adsorbierten Gasatomen bzw. -molekülen gesteuert werden.

In dieser Phase Ph$_1$ wird bevorzugterweise Reaktivgas bzw. Reaktivgasgemisch bei einem Partialdruck $p_p$ eingelassen, für welchen gilt

$$10^{-4} \text{ mbar} \leq p_p \leq 1 \text{ mbar}.$$

Im weiteren kann die Adsorptionsgeschwindigkeit, d.h. die Zeitspanne, welche benötigt wird, bis die Substratoberfläche zu einem vorgegebenen Prozentsatz mit Reaktivgas- bzw. Reaktivgasgemisch-Atomen oder -Molekülen abgesättigt ist, durch (nicht dargestelltes) Beheizen und/oder Kühlen der Substratoberfläche durch entsprechendes Beheizen und/oder Kühlen des Substratträgers 5 gesteuert werden.

Wie bereits eingangs erläutert wurde, werden in Phase $Ph_2$ das adsorbierte Gas an der Oberfläche des Substrates jedenfalls unter Mitwirkung von Gasionen und Elektronen, ggf. auch mittels in der Plasmaentladung gebildeter Radikalen eines zweiten Reaktivgases oder Reaktivgasgemisches $R_2$, reagiert. Auch durch entsprechende Bemessung der Zeitspanne, während welcher die Substratoberfläche mit adsorbiertem Gas der Plasmaentladung ausgesetzt ist sowie der Energie der Gasionen und Elektronen und mithin der Entladung sowie der Menge ggf. vorgesehener Radikalen und ihrer Aktivität, kann auch in dieser Phase $Ph_2$ die Menge "stabilisierter", vormals adsorbierter Gasatome bzw. -moleküle gesteuert werden und damit der letztendlich resultierende Belegungsgrad der Oberfläche mit Atomen bzw. Molekülen. In den meisten Fällen wird man bestrebt sein, eine durchgehende einmolekulare bzw. einatomare Monolage auf der Substratfläche zu realisieren, also mit hundertprozentiger Absättigung, bei der Atom an Atom liegen bzw. Molekül an Molekül.

Bevorzugterweise wird als Material der dem Prozessraum PR zugewandten Oberfläche 15 gemäss Fig. 1 ein dielektrisches Material eingesetzt. Es muss je nach dem, für welche Verfahrensphasen der Vakuumrezipient 3 eingesetzt wird, inert sein gegenüber dem Reaktivgas bzw. Reaktivgasgemisch $R_1$ und/oder gegenüber dem ggf. in Phase $Ph_2$ eingesetzten, plasmaaktivieren zweiten Reaktivgas bzw. Reaktivgasgemisch $R_2$.

Bevorzugterweise wird für diese Oberfläche 15 mindestens eines der in nachfolgender Gruppe G aufgeführten Materialien eingesetzt:

Quarz, Graphit, Siliziumkarbid, Siliziumnitrid, Aluminiumoxid, Titanoxid, Tantaloxid, Nioboxid, Zirkonoxid, diamantähnlicher Kohlenstoff oder Diamant, letztere Oberflächenmaterialien als Schichtmaterialien.

In Fig. 2 ist in einer Darstellung analog zu derjenigen von Fig. 1, weiterhin schematisch, eine bevorzugte Ausführungsform des erfindungsgemässen Typ I Prozessmoduls gemäss Fig. 1 dargestellt. Bezüglich Prozessführung, vorgesehene Gasvorräte sowie ggf. vorgesehene Plasmaentladungsstrecke gelten die im Zusammenhang mit Fig. 1 gemachten Ausführungen identisch, ebenso bezüglich Verfahrensführung. In Fig. 2 sind für die bereits in Fig. 1 beschriebenen Teile dieselben Bezugszeichen verwendet. Im Unterschied zur Ausführungsform gemäss Fig. 1 ist bei der Ausführungsform gemäss Fig. 2 der Prozessraum PR durch eine entlang überwiegender Abschnitte der Kammerwand 1, weiterhin bevorzugt aus rostfreiem Stahl bzw.

Inox, beabstandete Prozessraumwandung 14 begrenzt. Mindestens ihre dem Prozessraum PR zugewandte Oberfläche 15a ist aus dem bereits im Zusammenhang mit Fig. 1 erläuterten inerten Material gefertigt, wie erwähnt vorzugsweise aus dielektrischem, dabei weiterhin insbesondere bevorzugt aus mindestens einem der Materialien der Gruppe G.

Die eigentlich eine Prozessraumummantelung innerhalb der Vakuumkammer mit Wand 1 bildende Wandung 14 kann dabei aus dem die Oberfläche 15a bildenden Material bestehen, oder es ist das die Oberfläche 15a bildende inerte Material auf einer tragenden, der Wandung 1 zugewandten Wandung (nicht dargestellt) aufgebaut, wie beispielsweise aufgeschichtet. Diese Trägerwand ist dann, weil dem Prozessraum PR nicht ausgesetzt, beispielsweise aus rostfreiem Stahl bzw. Inox. Durch den Pumpanschluss 11 bzw. die Pumpe 13 wird der Prozessraum PR auf den im Zusammenhang mit Fig. 1 erläuterten Restgaspartialdruck abgepumpt, während beispielsweise - und wie in Fig. 2 gezeigt - der Zwischenraum ZW zwischen Vakuumkammerwand 1 und Ummantelung 14 über einen separaten Pumpanschluss 11a durch dieselbe oder durch eine andere Vakuumpumpe abgepumpt wird.

Der Fachmann erkennt ohne weiteres, dass auch beim Einsatz derselben Pumpe 13 zum Abpumpen beider Räume, nämlich des Prozessraumes PR sowie des Zwischenraumes ZW, entsprechende steuerbare Drosselorgane in den zugeordneten Pumpstutzen 11 bzw. 11a eingebaut werden können. Bezüglich des niederenergetischen Plasmas, welches zur Durchführung von Phase $Ph_2$ des erfindungsgemässen Verfahrens auch am Modul gemäss Fig. 2 eingesetzt wird, gelten die bereits im Zusammenhang mit Fig. 1 gemachten Erläuterungen. Die bei der Ausführungsform gemäss Fig. 2 vorgesehene, durch die Wandung 14 gebildete Prozessraumummantelung ist bevorzugterweise am Rezipienten 3a auswechselbar gestaltet.

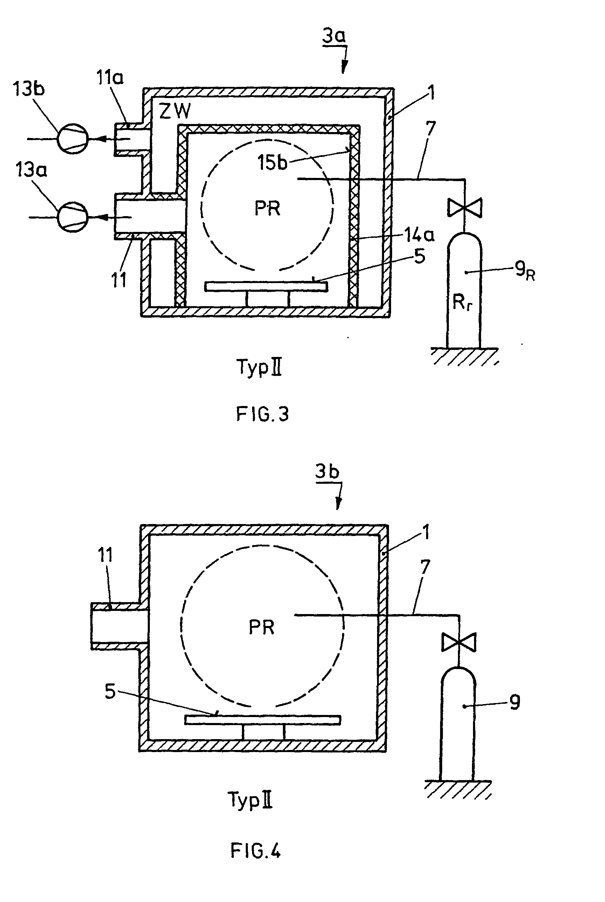

Das anschliessend zu erläuternde, in den Fig. 3 und 4 gezeigte Prozessmodul des Typs II wird im Rahmen des erfindungsgemässen Herstellungsverfahrens bevorzugterweise als Reinigungsmodul eingesetzt. Wie eingangs erwähnt wurde, ist es höchst vorteilhaft, die Substratoberfläche, bevor sie der Gasadsorption zugeführt wird, zu konditionieren bzw. zu reinigen. Bevorzugterweise erfolgt dies mit plasmaaktiviertem Reaktivgas oder Reaktivgasgemisch, vorzugsweise mittels plasmaaktiviertem Wasserstoff. Auch hier wird ein niederenergetisches Plasma eingesetzt mit Ionenenergien $E_r$ an der Substratoberfläche im oben angegebenen Bereich. Als Plasmaentladung wird dabei bevorzugt eine DC-Entladung eingesetzt, besonders bevorzugt eine unselbständige Entladung. Als dabei bevorzugte Ausführungsvariante wird wiederum eine Entladung mit thermionischer Kathode, insbesondere bevorzugt mit direkt beheizter, thermionischer Kathode eingesetzt.

Nebst dem Vorsehen eines derartigen Substratoberflächen-Konditionierungs- bzw. -Reinigungs-

schrittes vor der Gasadsorptionsphase $Ph_1$, insbesondere vor dem erstmaligen, kann es auch angezeigt sein, einen solchen Oberflächenbehandlungsschritt nach Beendigung der oben definierten Phase $Ph_2$ des erfindungsgemässen Verfahrens vorzusehen. Wie erwähnt werden hierzu bevorzugterweise die nachfolgend erläuterten Prozessmodule Typ II gemäss den Fig. 3 bzw. 4 eingesetzt.

Das in Fig. 3 dargestellte Modul unterscheidet sich von den in Fig. 2 dargestellten lediglich dadurch, dass die den Prozessraum PR umschliessende Oberfläche 15b den im Zusammenhang mit dem Prozessmodul gemäss Fig. 2 erläuterten Inertheits-Anforderungen nicht genügt, indem die Wandung 14a, beispielsweise wie die Wandung 1, aus rostfreiem Stahl bzw. Inox oder einem anderen Metall gefertigt ist. Dabei enthält die Gastankanordnung $9_R$ ein insbesondere zu Reinigungszwecken eingesetztes Reaktivgas bzw. Reaktivgasgemisch $R_r$, und es ist im Rezipienten 3a eine (nicht dargestellte) den obigen Anforderungen genügende, niederenergetische Plasmaentladungsstrecke vorgesehen.

Die metallische Wandung 14a ist bevorzugterweise auswechselbar, so dass das Prozessmodul Typ II in Ausführungsform gemäss Fig. 3 ohne weiteres in ein Prozessmodul Typ I gemäss Fig. 2 und umgekehrt gewandelt werden kann.

In Fig. 4 ist, weiterhin in Darstellung analog zu den Fig. 1 bis 3, eine weiter vereinfachte Ausführungsform des Moduls vom Typ II dargestellt. Im Unterschied zu dem anhand von Fig. 3 erläuterten ist hier der Prozessraum PR direkt durch die Kammerwandung 1 begrenzt, mit einer Oberfläche, die beispielsweise aus rostfreiem Stahl bzw. Inox besteht.

Es ist ohne weiteres ersichtlich, dass die Module Typ I gemäss Fig. 1 bzw. Fig. 2 und Typ II gemäss den Fig. 3 bzw. 4 durch entsprechendes Entfernen bzw. Einsetzen von Prozessraumummantelungen 14, 14a ineinander gewandelt werden können.

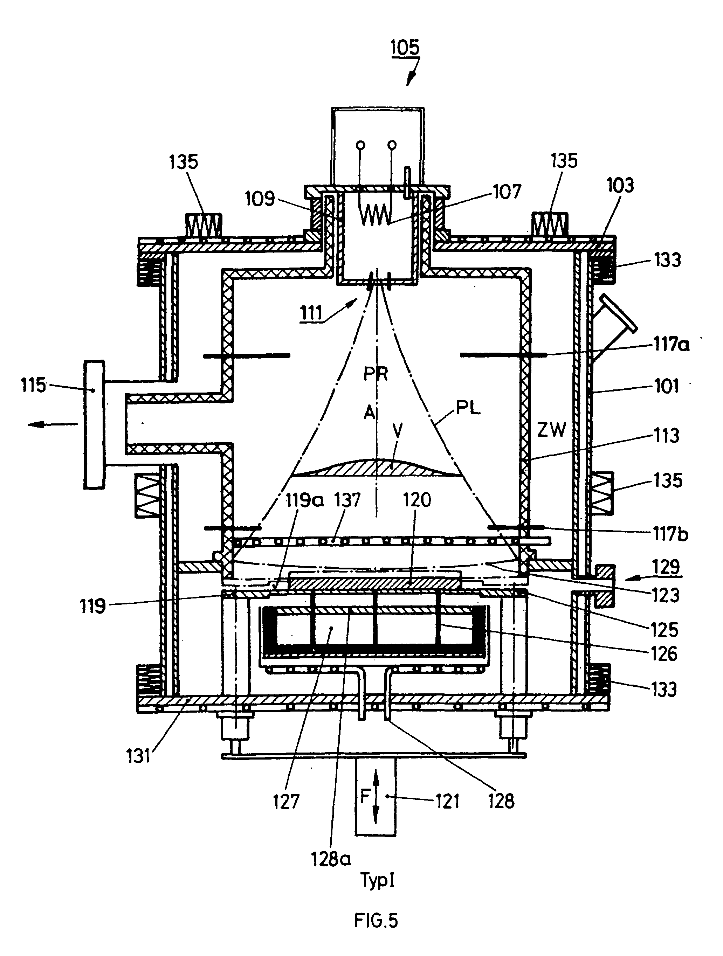

In Fig. 5 ist eine bevorzugte Realisationsform des Typ I Prozessmoduls gemäss Fig. 2 dargestellt. Es ist darauf hinzuweisen, dass alle vom Modul gemäss Fig. 2 ausgehenden, beim Modul gemäss Fig. 5 zusätzlichen, spezifisch bevorzugt eingesetzten Massnahmen, am prinzipiellen Modul gemäss Fig. 2 einzeln oder in beliebigen Teilkombinationen realisiert werden können. Das Prozessmodul gemäss Fig. 5 ist ausgelegt, um daran beide Phasen $Ph_1$ und $Ph_2$ des erfindungsgemässen Herstellungsverfahrens durchzuführen.

Entsprechend sind auch die Taktverhältnisse zeitgesteuert und die Gaszuführungen phasenabhängig gesteuert.

Die Rezipientenwand 101 des Prozessmoduls gemäss Fig. 5, vorzugsweise aus rostfreiem Stahl bzw. Inox gefertigt, trägt zentral, bevorzugterweise an ihrer oberen Stirnplatte 103, eine Elektronenquelle 105 zur Miterzeugung der Plasmaentladung im Prozessraum PR in Phase $Ph_2$ des erfindungsgemässen Herstellungsverfahrens. Bei den im Rahmen der erfindungsgemäss geforderten tiefen Ionenenergien im Substratbereich, auch für den Einsatz eines zweiten Reaktivgases bzw. Reaktivgasesgemisches in Phase $Ph_2$, können ggf. auch andere Plasmen, wie beispielsweise Mikrowellenplasmen, eingesetzt werden als das nachfolgend beschriebene.

Es wird bevorzugterweise eine Elektronenquelle, wie die Elektronenquelle 105, eingesetzt, welche Elektronen mit einer Elektronenenergie von höchstens 100 eV, vorzugsweise von höchstens 50 eV, abgibt. In bevorzugter Ausführungsform wird dabei die mit der Elektronenquelle unselbständige Entladung als DC-Entladung realisiert. Die Elektronenquelle 105 gemäss Fig. 5 ist bevorzugt gebildet durch eine thermionische Kathode, vorzugsweise eine direkt beheizte thermionische Kathode 107, eingebaut in eine Kathodenkammer 109 mit elektrisch von der Rezipientenwand 101, 103 isolierter Kathodenkammerwand. Die Kathodenkammer kommuniziert über eine Blende 111 mit dem Prozessraum PR. Das in Phase $Ph_2$ eingesetzte Edelgas, bevorzugterweise Argon, wird, weiter bevorzugt (nicht dargestellt), in die Kathodenkammer 109 eingelassen, unter anderem, um die thermionische Kathode 107 vor Einflüssen eines ggf. auch in Phase $Ph_2$ eingesetzten zweiten Reaktivgases bzw. Reaktivgasgemisches zu schützen und eine höhere Elektronenemissionsrate zu ermöglichen.

Von der Rezipientenwand 101, 103 beabstandet und mit ihr den Zwischenraum ZW aufspannend, ist, den Prozessraum PR umschliessend, die Prozessraumummantelung 113, in Analogie zu Fig. 2, vorzugsweise auswechselbar montiert. Der Prozessraum PR innerhalb der Ummantelung 113 sowie der Zwischenraum ZW werden hier über denselben Pumpanschluss 115 gepumpt. Dabei können ggf. unterschiedliche Pumpquerschnitte von diesem Anschluss 115 einerseits zum Zwischenraum ZW, andererseits zum Prozessraum PR führen.

Innerhalb des Prozessraumes PR wirkt, für die Verfahrensphase $Ph_2$, eine Anodenanordnung. Diese ist bevorzugterweise durch zwei oder mehrere konzentrisch zur Blendenachse A angeordnete Anoden 117a bzw. 117b gebildet. Sie sind (nicht dargestellt) je unabhängig voneinander auf Massepotential oder auf jeweilige elektrische Anodenpotentiale schaltbar, welche, weiter bevorzugt, unabhängig voneinander eingestellt werden können. Weiter bevorzugt ist die metallische Rezipientenwand 101, 103 auf Bezugspotential, vorzugsweise Massepotential, gelegt. Die entlang der Blendenachse A versetzten Anoden 117a, 117b sind, nebst unabhängig voneinander elektrisch betreibbar, bevorzugterweise (nicht dargestellt) auch unabhängig voneinander beheizbar bzw. kühlbar. Dies wird dadurch realisiert, dass in diesen Anoden Temperiermediumsleitungen geführt sind und/oder Heizwendeln eingebaut sind.

Strichpunktiert ist in Fig. 5 der durch die bevorzugt eingesetzte Plasmaerzeugungsanordnung gebildete Plasmastrahl PL dargestellt mit bei V rein heuristisch eingetragener Plasmadichteverteilung koaxial zur Blendenachse A. In Phase $Ph_2$ ist dabei die Substratoberfläche mit dem adsorbierten Reaktivgas direkt der Plasmaentladung PL ausgesetzt. Durch entsprechende Beaufschlagung der Anoden 117a und 117b mit anodischen Potentialen bzw. durch gesteuerte Temperierung dieser Anoden kann die Plasmadichteverteilung V gezielt eingestellt, insbesondere, über die Substratoberfläche, mindestens genähert konstant verteilt eingestellt werden.

Im Prozessraum PR ist ein Substrathalter 119 montiert bzw. ist, wie noch zu erläutern sein wird, dem Prozessraum PR gesteuerte zuführbar. Obwohl es durchaus möglich ist, den Substrathalter 119 für die bevorzugte Behandlung scheibenförmiger Substrate 120, eine Trägerfläche 119a definierend, mit dieser Trägerfläche 119a parallel zur Blendenachse A, diesbezüglich schiefwinklig oder diesbezüglich gemäss Fig. 5 senkrecht, aber exzentrisch anzuordnen, wird in weitaus bevorzugter Ausführungsform der Substrathalter 119 mit seiner Trägerfläche 119a zur Achse A der Blende 111 konzentrisch und im wesentlichen senkrecht angeordnet.

In einer weiteren bevorzugten Ausführungsform ist mittels eines externen Antriebes 121 der Substrathalter 119, wie mit dem Doppelpfeil F dargestellt, gegen die durch die Prozessraumummantelung 113 definierte lichte Aufnahmeöffnung 123 hin- bzw. von ihr rückholbar. Ist der Substrathalter 119 mittels des Antriebes 121 vollständig gegen den Prozessraum PR hochgefahren, so verschliesst seine Randpartie 125 die lichte Öffnung 123 der Prozessraumummantelung 113 mindestens so, dass in der Phase $Ph_2$ Ladungsträger gehindert werden, aus dem Prozessraum PR auszutreten und in der Verfahrensphase $Ph_1$ nachhaltig verhindert wird, dass zu adsorbierendes Reaktivgas oder Reaktivgasgemisch in den Zwischenraum ZW austritt.

Ein wie erwähnt bevorzugt flächiges bzw. scheibenförmiges Substrat 120 wird durch ein Schlitzventil 129 auf stationäre Aufnahmestützen 126 abgelegt, während der Substrathalter 119 abgesenkt ist. Danach wird der Substrathalter 119 angehoben, untergreift mit seiner Trägerfläche 119a das Substrat 120 und hebt dieses von den stationären Stützen 126 ab. Das Substrat 120 wird hochbewegt in den Prozessraum PR, dabei, bei Erreichen der Bearbeitungsposition, verschliesst der Substrathalter 119 mit seiner Randfläche 125 den Prozessraum im erwähnten Ausmasse.

Die Stützen 126 sind an einer Substrattemperiereinrichtung 127 montiert, welche über Temperiermedium-Zu- und - Ableitungen 128 Temperiermedium-beaufschlagt ist. Wie erwähnt kann durch entsprechende Steuerung der Substratoberflächen-Temperatur, insbesondere in Phase $Ph_1$, die Gasadsorptionsrate gesteuert werden.

Gestrichelt ist in Fig. 5 der Substrathalter 119 in seiner Bearbeitungsposition dargestellt.

Auch die Rezipientenwandung 101 und deren stirnseitige Abschlussplatten 103 bzw. 131 sind temperiert, vorzugsweise gekühlt, insbesondere in Phase $Ph_2$ des erfinungsgemässen Herstellungsverfahrens. Hierzu ist die die Ummantelung bildenden Wandung 101 als Doppelwandung ausgebildet mit dazwischen eingebautem Temperiermediumssystem. Ebenso sind in den Stirnplatten 103 bzw. 131 Temperiermedium-Leitungssysteme eingebaut.

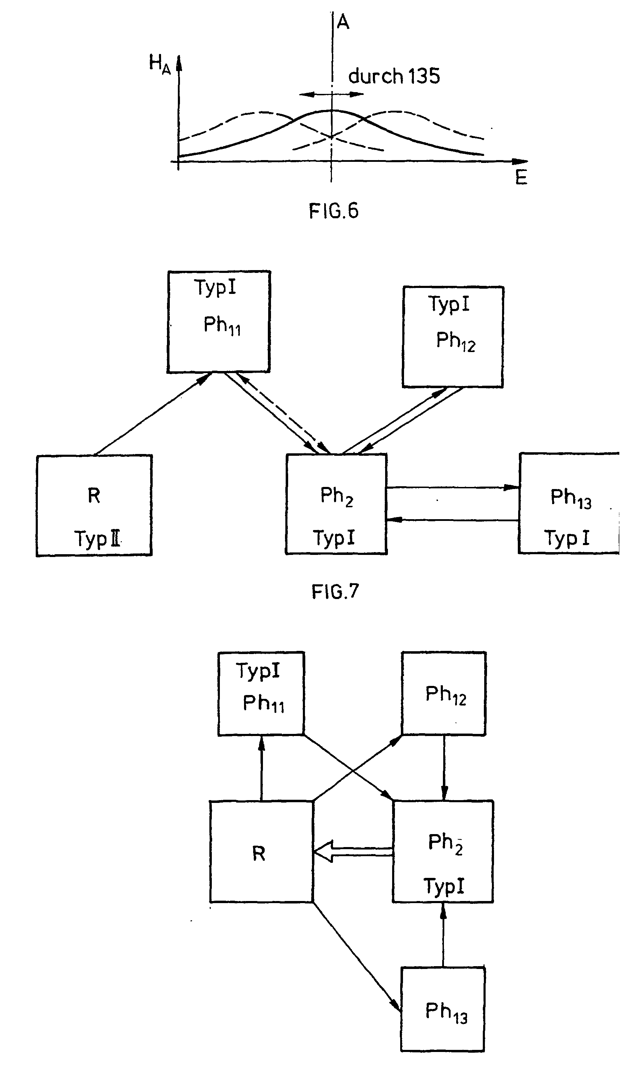

Ausserhalb des Vakuumrezipienten sind Helmholtz-Spulen 133 sowie, verteilt, Umlenkspulen 135 montiert. Mittels der Helmholtz-Spulen 133 wird ein im wesentlichen zur Achse A paralleles und diesbezüglich symmetrisches Magnetfeldmuster im Prozessraum PR erzeugt, dies insbesondere in Phase $Ph_2$ des erfindungsgemässen Herstellungsverfahrens. Dieses Magnetfeldmuster kann mit Hilfe der Umlenkspulen 135 in Ebenen E senkrecht zur Achse A , wie in Fig. 6 schematisch dargestellt, verschoben werden. Durch diese "Verschiebung" der Magnetfeldstärkeverteilung $H_A$ ergibt sich eine "Verschiebung" der Plasmadichteverteilung V entlang des Substrates 120. Damit wird eine "Relativbewegung" zwischen Plasmadichteverteilung V und zu behandelnder Substratoberfläche erreicht, wie wenn das Substrat bezüglich des Plasmas PL mit zeitlich konstanter Plasmadichteverteilung verschoben würde. Durch diese Feldverteilungssteuerung ergibt sich am Substrat mithin der gleiche Effekt, wie wenn dieses bezüglich des Plasmas PL mechanisch bewegt würde, ohne aber eine mechanische Substratbewegung vorzusehen.

Für die Realisierung der Phase $Ph_1$ des erfindungsgemässen Verfahrens wird zu adsorbierendes Reaktivgas oder Reaktivgasgemisch, nachdem das bevorzugterweise vorgängig gereinigte Substrat 120 in Bearbeitungsposition gefahren wurde, über Reaktivgaseinlass 137 in den Prozessraum PR eingelassen. Dabei ist wie dargestellt der Reaktivgascinlass, vorzugsweise koaxial zur Achse A, im unmittelbaren Bereich des in Bearbeitungsposition liegenden Substrates 120 bzw. Substratträgers 119 angeordnet, mit Einlassöffnungen im wesentlichen parallel zu der zu behandelnden Substratfläche. Wie erwähnt wurde, ist der bevorzugt aus rostfreiem Stahl aufgebaute Vakuumrezipient 101, 103 insbesondere in Phase $Ph_2$ bevorzugt intensiv gekühlt. Er genügt UHV-Bedingungen. Die intensive Kühlung in Phase $Ph_2$ verhindert das Aufheizen des Stahls und die damit verbundene Freisetzung von kohlenstoffhaltigen Gasen aus dem Stahl, insbesondere während der Phase $Ph_2$.

Bezüglich des Materials der Prozessraumummantelung 113, insbesondere deren dem Prozess ausgesetzten Oberfläche, gilt das bereits anhand von Fig. 1 Erläuterte: Das inerte Material, vorzugsweise ein dielektrisches und wie erwähnt bevorzugt aus der Materialgruppe G gewählt, ist auch bei wesentlich höheren Temperaturen als der Prozesstemperatur stabil bezüglich verwendeten, zu adsorbierenden Reaktivgasen $R_1$ (Fig. 1) und den ggf. der Plasmaentladungsatmosphäre in Phase $Ph_2$ zugeführten zweiten Reaktivgasen ($R_2$), wie insbesondere bezüglich Wasserstoff, Silan, German, Diboran, Chlor, $NF_3$, HCl, $SiH_3CH_3$, $GeH_3CH_3$, $N_2$, $ClF_3$, $PH_3$, $AsH_4$. Damit wird erreicht, dass es zu keinen Kontaminationen des Substrates 120 kommt. Eine Störbeschichtung der inneren Oberfläche der Prozessraumummantelung 113 ist nur unter dem Aspekt der Partikelbildung kritisch. Eine dünne Störbeschichtung durch Gasadsorption und anschliessende Plasmabehandlung kann sogar bevorzugt werden, um eine noch bessere Reinheit des Prozesses zu gewährleisten, der dann praktisch ausschliesslich durch Prozess-inhärentes Material umgeben ist.

Bei den Typ I Prozessmodulen wird die Vakuumkammerwand üblicherweise aus rostfreiem Stahl nicht beschichtet, weil sie durch die Prozessraumummantelung 113 vor den reaktiven Gasen und dem Plasma geschützt ist, weiter weil die wie in Fig. 5 dargestellte intensive Kühlung eine Abscheidung aus der Gasphase dort zusätzlich stark reduziert. Was bezüglich der inneren Oberfläche der Prozessraumummantelung 113 gilt, gilt auch für dem Prozess ausgesetzten Oberflächen des Substrathalters 119.

Die Prozessraumummantelung 113 wird bevorzugterweise mehrteilig (nicht dargestellt) ausgebildet, so dass sie ohne Demontage der Anordnungen 117a, 117b entfernt bzw. ausgewechselt werden kann.

Durch Entfernen der in Fig. 5 dargestellten Prozessraumummantelung 113 wird eine bevorzugte Ausführungsform des Prozessmoduls Typ II realisiert, bzw. durch Ersatz der Prozessraumummantelung 113 durch eine ebenso geformte Ummantelung aus einem Metall, ein Prozessmodul des Typs II gemäss Fig. 3.

Es sei wiederholt, dass im Prozessmodul des Typs I, bevorzugt ausgebildet gemäss Fig. 5, die Phasen $Ph_1$ und/oder $Ph_2$ des erfindungsgemässen Herstellungsverfahrens durchgeführt werden, hingegen bevorzugterweise in Modulen des Typs II der Phase $Ph_1$ vorgelagerte und/oder der Phase $Ph_2$ nachgelagerte Oberflächen-Konditionierungs- bzw. -Reinigungsschritte, bevorzugt in einem niederenergetischen Wasserstoffplasma.

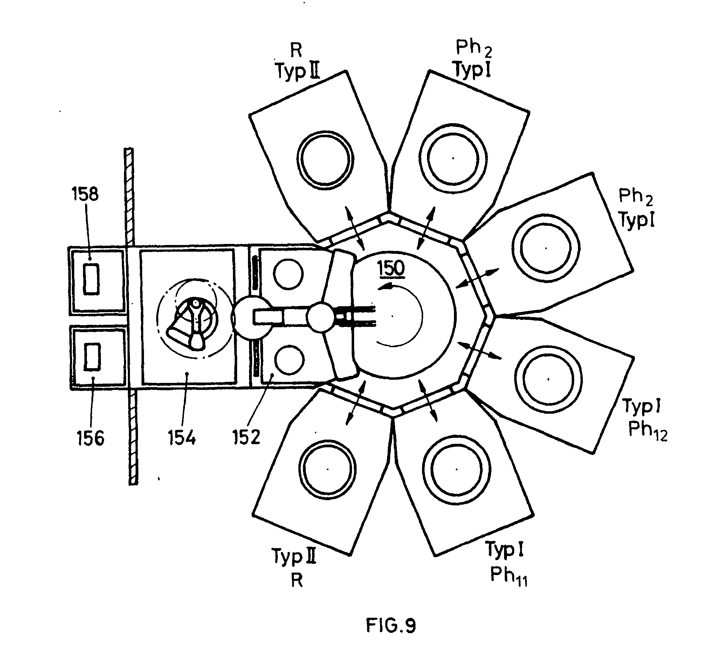

In den Fig. 7 und 8 sind in Form von Ablaufdiagrammen zwei mögliche Realisationsformen des erfindungsgemässen Herstellungsverfahrens dargestellt. Gemäss Fig. 7 seien mehrere unterschiedliche Atom-Monolagen übereinander abzulegen, beispielsweise zur Herstellung einer heteroepitaktisch aufgewachsenen Schicht. Die Substrate werden erst einem Reinigungsmodul R, vorzugsweise ausgebildet gemäss den Modulen Typ II, zugeführt, worin, weiter bevorzugt, eine Oberflächenreinigung in einem wie definiert niederenergetischen Wasserstoffplasma erfolgt. Ein betrachtetes Substrat wird nach Reinigung R einem Prozessmodul des Typs I zugeführt, worin die Verfahrensphase $Ph_{11}$ mit Absorption eines ersten Reaktivgases erfolgt.

Anschliessend wird das Substrat zur Realisation der Phase $Ph_2$ einem Prozessmodul, bevorzugterweise des Typs I, zugeführt mit, wie erwähnt wurde, Gaszuführung - Edelgas und/oder Reaktivgas - und niederenergetischer Plasmaentladung. Nach Durchführung der Phase $Ph_2$ wird das Substrat einem weiteren Prozessmodul des Typs I zugeführt und dort mit einem weiteren zu adsorbierenden Reaktivgas oder Reaktivgasgemisch - $Ph_{12}$ - beaufschlagt. Wiederum wird es danach im zentralen Prozessmodul des Typs I der Verfahrensphase $Ph_2$ unterzogen, um danach ggf. weiteren Prozessmodulen des Typs I zugeführt zu werden, wo das Substrat weiteren zu adsorbierenden Reaktivgasgemischen bzw. Reaktivgasen unterworfen wird, $Ph_{13}$ etc.

Dadurch werden, sollen epitaktische Schichte aufgewachsen werden, heteroepitaktische Schichten abgelegt. Pendelt das Substrat, wie gestrichelt dargestellt, zwischen Prozessphase $Ph_2$ und einer Prozessphase, z.B. $Ph_{11}$, hin und her, so wird im Falle epitaktischen Aufwachsens eine homoepitaktische Schicht aufgewachsen.

Im Unterschied zur Durchführung des erfindungsgemässen Verfahrens nach Fig. 7 wird bei der Durchführung gemäss Fig. 8 vorzugsweise nach jedem Ablegen einer Atom-Monolage ein Reinigungsschritt der Substratoberfläche vorgenommen. Dabei kann dieser Reinigungsschritt R bevorzugterweise immer gleich ausgebildet sein wie der Reinigungsschritt, welcher an der Substratoberfläche durchgeführt wird, bevor sie überhaupt dem ersten Adsorptionsschritt gemäss einer ersten Verfahrensphase $Ph_{11}$ unterzogen wird. Es wird also auch nach Ablegen einer atomaren Monolage eine Oberflächenreinigung am Substrat durchgeführt, in einem niederenergetischen Plasma, vorzugsweise einem niederenergetischen Wasserstoffplasma. Folgen wir wiederum einem betrachteten Substrat. Nach Reinigung im Prozess R wird es einem ersten Prozessmodul des Typs I zugeführt, wo es ein erstes Reaktivgas bzw. Reaktivgasgemisch adsorbiert, $Ph_{11}$. Anschliessend wird es einem weiteren Prozessmodul des Typs I zugeführt, woran die Verfahrensphase $Ph_2$, d.h. Plasmabehandlung, ggf. unter Beifügung von Ionen und Radikalen eines zweiten plasmaaktivierten Reaktivgases, insbesondere bevorzugt von Wasserstoff und/oder Stickstoff und/oder Sauerstoff, durchgeführt wird.

Nach Beendigung dieser Verfahrensphase $Ph_2$ wird das Substrat wiederum dem Reinigungsprozess R, bevorzugt in einem Modul des Typs II, zugeführt, danach einem weiteren Modul des Typs I, wo es ein weiteres Reaktivgas bzw. Reaktivgasgemisch, in der Phase $Ph_{12}$, adsorbiert. Es wird danach, wiederum über die Verfahrensphase $Ph_2$, dem Reinigungsschritt R zugeführt, etc. Hier ist ersichtlich, dass, ausgangsseitig der die Prozessphasen $Ph_{1x}$ durchführenden Module, ein Transport über ein die Phase $Ph_2$ durchführendes Modul zum Reinigungsmodul erfolgt, von wo aus, praktisch zentral, die die jeweilige Phase $Ph_{1x}$ durchführenden Prozessmodule mit Substraten gespiesen werden.

Bevorzugterweise werden diese oder gleichgeartete, relativ komplexe Prozessabfolgen flexibel in einer vorzugsweise frei programmierbaren Vakuumbehandlungsanlage durchgeführt, innerhalb welcher ein zentrales Transportmodul die jeweiligen Prozess- und Konditionierungs- bzw. Reinigungsmodule beschickt.

Schematisch und rein beispielsweise ist eine solche Anlage in Fig. 9 dargestellt, mit zwei Reinigungsmodulen R des Typs II, zwei Modulen des Typs I zur Durchführung der Verfahrensphasen $Ph_2$ sowie zwei Modulen des Typs I zur Durchführung der Verfahrensphasen $Ph_{12}$ und $Ph_{11}$.

### Patentansprüche

1. Verfahren zur Herstellung materialbeaufschlagter Substrate, bei dem:

    a) mindestens ein Substrat in einen evakuierten Vakuumrezipienten eingeführt wird;

    b) die zu beaufschlagende Oberfläche des Substrates einem Reaktivgas ausgesetzt wird, das an der Oberfläche adsorbiert wird;

    c) die Aussetzung der Oberfläche an das Reaktivgas beendet wird;

    d) das an der Oberfläche adsorbierte Reaktivgas reagiert wird, **dadurch gekennzeichnet, dass**

    $d_1$) die Oberfläche mit dem adsorbierten Gas einer niederenergetischen Plasmaentladung mit Ionenenergie $E_{Io}$ an der Substratoberfläche von

    $$0 \text{ eV} < E_{Io} \leq 20 \text{ eV}$$

    und Elektronenenergie $E_{eo}$

    $$0 \text{ eV} < E_{eo} \leq 100 \text{ eV}$$

    ausgesetzt wird;

    $d_2$) das adsorbierte Reaktivgas mindestens unter Mitwirkung von plasmaerzeugten Ionen und Elektronen reagiert wird.

2. Verfahren nach Anspruch 1, **dadurch gekennzeichnet, dass** die Plasmaentladung mit einer Ionenenergie $E_{Io}$ an der Oberfläche des Substrates von

$$0 \text{ eV} < E_{Io} \leq 15 \text{ eV}$$

realisiert wird.

3. Verfahren nach einem der Ansprüche 1 oder 2, **dadurch gekennzeichnet, dass** das adsorbierte Reaktivgas eine Reaktivgasgemisch ist.

4. Verfahren nach einem der Ansprüche 1 bis 3, **dadurch gekennzeichnet, dass** die Plasmaentladung in einer Edelgas-Atmosphäre unterhalten wird.

5. Verfahren nach Anspruch 4, **dadurch gekennzeichnet, dass** die Plasmaentladung in einer Argon-Atmosphäre unterhalten wird.

6. Verfahren nach einem der Ansprüche 1 bis 5, **dadurch gekennzeichnet, dass** die Plasmaentladung in einer Atmosphäre erzeugt wird, welche ein weiteres Reaktivgas oder -Gasgemisch enthält.

7. Verfahren nach Anspruch 6, **dadurch gekennzeichnet, dass** das weitere Reaktivgas oder -Gasgemisch mindestens eines der Gase Wasserstoff, Stickstoff, Sauerstoff enthält.

8. Verfahren nach Anspruch 6, **dadurch gekennzeichnet, dass** das weitere Reaktivgas oder -Gasgemisch Wasserstoff enthält, vorzugsweise Wasserstoff ist.

9. Verfahren nach einem der Ansprüche 1 bis 8, **dadurch gekennzeichnet, dass** man den Vakuumrezipienten auf einen Druck ($p_v$) evakuiert, für den gilt:

    $$10^{-11} \text{ mbar} \leq p_v \leq 10^{-8} \text{ mbar.}$$

10. Verfahren nach einem der Ansprüche 1 bis 9, **dadurch gekennzeichnet, dass** man das zu adsorbierende Reaktivgas bis zu einem Partialdruck pp einlässt, für welches gilt

    $$10^{-4} \text{ mbar} \leq p_p \leq 1 \text{ mbar.}$$

11. Verfahren nach einem der Ansprüche 1 bis 10, **dadurch gekennzeichnet, dass** die Gasabsorptions-Rate an der Oberfläche durch Beheizen/Kühlen der Oberfläche gesteuert wird.

12. Verfahren nach einem der Ansprüche 1 bis 11, **dadurch gekennzeichnet, dass** man die Aussetzung beendet, indem man das Substrat aus dem evakuierten Vakuumrezipienten in einen weiteren evakuierten Vakuumrezipienten überführt.

**13.** Verfahren nach einem der Ansprüche 1 bis 12, **dadurch gekennzeichnet, dass** man die Aussetzung der Oberfläche beendet durch Abpumpen des verbleibenden adsorbierten Reaktivgases aus dem evakuierten Vakuumrezipienten.

**14.** Verfahren nach Anspruch 13, **dadurch gekennzeichnet, dass** man das Reaktivgas bis zum Erreichen eines Druckes $p_v'$ abpumpt, für welchen gilt:

$$10^{-11} \text{ mbar} \leq p_v' \leq 10^{-8} \text{ mbar}.$$

**15.** Verfahren nach Anspruch 1 bis 14, **dadurch gekennzeichnet, dass** man das Substrat der Plasmabehandlung mindestens während einer vorgegebenen Minimal-Zeitspanne aussetzt.

**16.** Verfahren nach einem der Ansprüche 1 bis 15, **dadurch gekennzeichnet, dass** man mindestens die Schritte b) bis $d_2$) mindestens zweimal durchläuft.

**17.** Verfahren nach einem der Ansprüche 1 bis 16, **dadurch gekennzeichnet, dass** man nach Durchführen mindestens eines Schrittes $d_2$) ein geändertes Material auf die Oberfläche aufbringt.

**18.** Verfahren nach Anspruch 17, **dadurch gekennzeichnet, dass** man das weitere Material mittels eines Vakuumbeschichtungsprozesses, nasschemisch oder galvanisch aufbringt.

**19.** Verfahren nach einem der Ansprüche 1 - 18, **dadurch gekennzeichnet, dass** man vor dem Aussetzen der Oberfläche dem zu adsorbierenden Reaktivgas die Oberfläche einem niederenergetiscehn Edelgasplasma, vorzugsweise Argon-Plasma, aussetzt mit Ionenenergien $E_{I1}$ an der Oberfläche von

$$0 \text{ eV} < E_{I1} \leq 20 \text{ eV},$$

vorzugsweise

$$0 \text{ eV} < E_{I1} \leq 15 \text{ eV}$$

und Elektronenenergie $E_{e1}$ von

$$0 \text{ eV} < E_{e1} \leq 100 \text{ eV}.$$

**20.** Verfahren nach einem der Ansprüche 1 - 19, **dadurch gekennzeichnet, dass** man, vor dem Aussetzen der Oberfläche dem zu adsorbierenden Reaktivgas, die Oberfläche einer niederenergetischen Plasmaentladung in einer Atomatmosphäre, die ein weiteres Reaktivgas enthält, aussetzt, wobei für die Ionenenergie $E_{I2}$ an der Substratoberfläche gilt:

$$0 \text{ eV} < E_{I2} \leq 20 \text{ eV}$$

vorzugsweise

$$0 \text{ eV} < E_{I2} \leq 15 \text{ eV}$$

bei Elektronenenergie $E_{e2}$ von

$$0 \text{ eV} < E_{e2} \leq 100 \text{ eV}.$$

**21.** Verfahren nach Anspruch 20, **dadurch gekennzeichnet, dass** das weitere Reaktivgas mindestens eines der Gase Wasserstoff, Stickstoff, Sauerstoff ist.

**22.** Verfahren nach Anspruch 20, **dadurch gekennzeichnet, dass** das weitere Reaktivgas Wasserstoff enthält, vorzugsweise Wasserstoff ist.

**23.** Verfahren nach einem der Ansprüche 1 - 22, **dadurch gekennzeichnet, dass** man nach dem Reagieren des adsorbierten Reaktivgases die Oberfläche einem niederenergetischen Edelgasplasma, vorzugsweise Argon-Plasma, aussetzt mit einer Ionenenergie $E_{I3}$ an der Oberfläche von

$$0 \text{ eV} < E_{I3} \leq 20 \text{ eV},$$

vorzugsweise

$$0 \text{ eV} < E_{I3} \leq 15 \text{ eV}$$

und Elektronenenergie $E_{e3}$

$$0 \text{ eV} < E_{e3} \leq 100 \text{ eV}.$$

**24.** Verfahren nach einem der Ansprüche 1 - 23, **dadurch gekennzeichnet, dass** man, nach dem Reagieren des adsorbierten Reaktivgases, die Oberfläche einer niederenergetischen Plasmaentladung in einer Atmosphäre, die ein weiteres Reaktivgas enthält, aussetzt, wobei für die Ionenenergie $E_{I4}$ an der Substratoberfläche gilt:

$$0 \text{ eV} < E_{I4} \leq 20 \text{ eV},$$

vorzugsweise

$$0\ eV < E_{I4} \le 15\ eV$$

und mit Elektronenenergie $E_{e4}$

$$0\ eV < E_{e4} \le 100\ eV.$$

25. Verfahren nach Anspruch 24, **dadurch gekennzeichnet, dass** das weitere Reaktivgas mindestens eines der Gase Wasserstoff, Stickstoff, Sauerstoff ist.

26. Verfahren nach Anspruch 24, **dadurch gekennzeichnet, dass** das weitere Reaktivgas Wasserstoff enthält, vorzugsweise ist.

27. Verfahren nach einem der Ansprüche 1 - 26, **dadurch gekennzeichnet, dass** die Oberflächenbeaufschlagung mittels mindestens einem der folgenden Materialien erfolgt:

Oxide oder Nitride oder Oxinitride von Si, Ge, Ti, Ta, Hf, Zr, Al, Nb, W und/oder der folgenden Metalle:

Al, Ti, Cu, W, Ta.

28. Verfahren nach Anspruch 27, **dadurch gekennzeichnet, dass** die Oberflächenbaufschlagung mittels mindestens einem der folgenden Materialien erfolgt:

Siliziumoxid, Tantaloxid, Zirkonoxid, Titannitrid, Tantalnitrid, Wolframnitrid, $(TaSi)_xNy$.

29. Verfahren nach einem der Ansprüche 1 - 26, **dadurch gekennzeichnet, dass** alle Verfahrensschritte in einem Vakuumrezipienten durchgeführt werden.

30. Verfahren nach einem der Ansprüche 1 - 26, **dadurch gekennzeichnet, dass** die Verfahrensschritte in mindestens zwei Vakuumrezipienten durchgeführt werden.

31. Verfahren nach einem der Ansprüche 1 bis 30, **dadurch gekennzeichnet, dass** die die Oberfläche des Substrates umgebende Prozessatmosphäre während mindestens einer der Phasen, bestehend aus den Schritten b) und c) und/oder d) bis $d_2$), von der Innenwand eines an Umgebung liegenden Vakuumrezipienten getrennt wird.

32. Verfahren nach einem der Ansprüche 1 bis 31, **dadurch gekennzeichnet, dass** die zu beaufschlagende Oberfläche die Oberfläche eines bereits beaufschlagten oder beschichteten Substrates umfasst.

33. Verfahren nach einem der Ansprüche 1 bis 32, **dadurch gekennzeichnet, dass** die Oberfläche vor dem Absorptionsschritt und/oder nach dem Reagieren des adsorbierten Reaktivgases oder -gasgemisches einem plasmaunterstützten Reinigungsschritt ausgesetzt wird, bei dem in einen Prozessraum eingelassenen Reaktivgas oder - gasgemisch - vorzugsweise Wasserstoff enthaltend - mittels einer niederenergetischen Plasmaentladung mit Ionenenergie Er an der Substratoberfläche von

$$0\ eV < E_r \le 20\ eV,$$

vorzugsweise

$$0\ eV < E_r \le 15\ eV$$

aktiviert wird, bei einer Elektronenenergie $E_{er}$ von

$$0\ eV < E_{er} \le 100\ eV.$$

34. Verfahren nach Anspruch 33, **dadurch gekennzeichnet, dass** während des mindestens einen Reinigungsschrittes die Reinigungsprozessatmosphäre mittels einer metallischen Umkapselung von der Innenwandung des an Umgebung liegenden Reinigungsvakuumrezipienten abgetrennt wird oder - und dies bevorzugt - diese Prozessatmosphäre direkt durch die Innenwandung eines an Umgebung liegenden Reinigungsvakuumrezipienten begrenzt wird.

35. Verfahren nach einem der Ansprüche 1 bis 34, **dadurch gekennzeichnet, dass** man durch eine einzige Abfolge der Schritte a) bis $d_2$) eine Atom-Monolage auf die Oberfläche aufbringt.

36. Verfahren nach einem der Ansprüche 1 bis 35, **dadurch gekennzeichnet, dass** man durch Wiederholen der Schritte b) bis d) eine epitaktische Schicht aufwächst, mit Reaktivgaswechsel heteroepitaktische, ohne Reaktivgaswechel homoepitaktische.

37. Verfahren nach einem der Ansprüche 1 bis 36, **dadurch gekennzeichnet, dass** man nach Durchführung einer vorgegebenen Anzahl Durchläufe der Schritte b) bis d) sequentiell an mehreren Substraten den Prozessraum des Vakuumrezipienten einem plasmaunterstützten Prozessraum-Reinigungsschritt ohne eingeführtes Substrat unterzieht oder mit Substrat-Attrappe, welcher Prozessraum-Reinigungsschritt bevorzugt erst einen Ätzschritt umfasst, danach einen Reinigungsschritt, bevorzugt in einem Plasma, enthaltend Wasserstoff, Edelgas oder eine Mischung daraus.

38. Verfahren nach einem der Ansprüche 1 bis 37, **dadurch gekennzeichnet, dass** man vor Schritt a) und/oder nach Schritt $d_2$) das Substrat örtlich vom Vakuumrezipienten getrennt einem Substratreinigungsschritt unterzieht und den Transport des Substrates dazwischen in Vakuum vornimmt.

39. Verfahren nach Anspruch 38, **dadurch gekennzeichnet, dass** der Transport in Vakuum mindestens stückweise linear erfolgt oder, und bevorzugt, entlang einer Kreisbahn, mit linearen Zuführbewegungen zu den erwähnten Rezipienten, vorzugsweise mit bezüglich Kreisbahn radialer Bewegungskomponente.

40. Verfahren nach einem der Ansprüche 1 bis 39, **dadurch gekennzeichnet, dass** man während den Schritten b) bis und mit d) die Prozessatmosphäre, welcher die Oberfläche ausgesetzt ist, von der Innenwandung eines an Umgebung liegenden Vakuumrezipienten trennt mittels einer im Neuzustand chemisch gegen das zu adsorbierende Reaktivgas oder -gasgemisch und/oder gegen ein zweites plasmaaktiviertes Reaktivgas oder -gasgemisch inerten Oberfläche, vorzugsweise mittels einer dielektrischen oder graphitischen Oberfläche.

41. Verfahren nach Anspruch 40, **dadurch gekennzeichnet, dass** die inerte Oberfläche die Oberfläche einer Trennwand ist, die entlang überwiegender Flächenabschnitte von der Innenwandung des Vakuumrezipienten beabstandet wird.

42. Verfahren nach mindestens einem der Ansprüche 40 oder 41, **dadurch gekennzeichnet, dass** die Oberfläche zur Trennung im Neuzustand aus mindestens einem der folgenden Materialien realisiert wird:

Quarz, Graphit, Siliziumkarbid, Siliziumnitrid, Aluminiumoxid, Titanoxid, Tantaloxid, Nioboxid, Zirkonoxid oder einer geschichteten Kombination dieser Materialien, dann auch mit diamantähnlichem Kohlenstoff oder Diamant.

43. Verfahren nach einem der Ansprüche 1 bis 42, **dadurch gekennzeichnet, dass** man die Plasmaentladung mit einer Elektronenquelle mit Elektronenenergie $E_e \le 50$ eV, insbesondere bevorzugt mittels einer DC-Entladung realisiert.

44. Verfahren nach einem Ansprüche 1 bis 43, **dadurch gekennzeichnet, dass** man die Plasmaentladung mittels einer thermionischen Kathode, vorzugsweise mit einer direkt beheizten thermionischen Kathode, realisiert.

45. Verfahren nach einem der Ansprüche 1 bis 44, **dadurch gekennzeichnet, dass** man im Prozessraum des Vakuumrezipienten für die Plasmaentladung mindestens zwei örtlich versetzte und vorzugsweise je beheizbare Anoden vorsieht, vorzugsweise je getrennt elektrisch betätigbar und durch Steuerung der je daran angelegten elektrischen Potentiale und/oder ihrer Temperatur die Plasmadichteverteilung entlang der Oberfläche dynamisch oder statisch einstellt oder steuert.

46. Verfahren nach einem der Ansprüche 1 bis 45, **dadurch gekennzeichnet, dass** man während dem Schritt d) im Prozessraum ein Magnetfeld erzeugt und mittels dieses Magnetfeldes stationär und/oder dynamisch die Plasmadichteverteilung entlang der Oberfläche einstellt oder steuert, vorzugsweise mindestens örtlich wobbelnd.

47. Verfahren nach einem der Ansprüche 1 bis 46, **dadurch gekennzeichnet, dass** mindestens das zu adsorbierende Reaktivgas oder -gasgemisch verteilt in die Prozessatmosphäre eingelassen wird, vorzugsweise mit einer Einströmrichtung im wesentlichen parallel zur Oberfläche und, weiter bevorzugt, mit von der Oberfläche äquidistanten Eindüsungsstellen.

48. Verfahren nach einem der Ansprüche 1 bis 47, **dadurch gekennzeichnet, dass** das Substrat ein Siliziumoxid-beschichtetes Substrat ist mit in die Siliziumoxidschicht eingelassenen Kerben, und dass nach n-maligem Durchführen eines der Schritte $d_2$) in die Kerben Kupfer abgelegt wird, wobei n $\ge$ 1 ist.

49. Verwendung des Verfahrens nach einem der Ansprüche 1 - 48 für die Herstellung relaxierter Puffer.

**Claims**

1. Method for manufacturing substrates provided with material on their surfaces, in which:

a) at least one substrate is introduced into an evacuated vacuum recipient;
b) the substrate surface to be provided with material is exposed to a reactive gas which is adsorbed on the surface;
c) the exposure of the surface to the reactive gas is terminated;
d) the reactive gas adsorbed on the surface is reacted;

**characterised in that**

$d_1$) the surface with the adsorbed gas is exposed to a low-energetic plasma discharge with ion energy $E_{Io}$ at the substrate surface of

$$0 \text{ eV} < E_{Io} \leq 20 \text{ eV}$$

and an electron energy $E_{eo}$ of

$$0 \text{ eV} < E_{eo} \leq 100 \text{ eV};$$

$d_2$) the adsorbed reactive gas is reacted at least with the co-operation of plasma-generated ions and electrons.

2. Method according to claim 1, **characterised in that** the plasma discharge is performed with an ion energy $E_{Io}$ at the substrate surface of

$$0 \text{ eV} < E_{Io} \leq 15 \text{ eV}.$$

3. Method according to one of claims 1 or 2, **characterised in that** the adsorbed reactive gas is a reactive gas mixture.

4. Method according to any of claims 1 to 3, **characterised in that** the plasma discharge is maintained in an inert gas atmosphere.

5. Method according to claim 4, **characterised in that** the plasma discharge is maintained in an argon atmosphere.

6. Method according to any of claims 1 to 5, **characterised in that** the plasma discharge is generated in an atmosphere which contains a further reactive gas or reactive gas mixture.

7. Method according to claim 6, **characterised in that** the further reactive gas or reactive gas mixture contains at least one of the gases hydrogen, nitrogen, oxygen.

8. Method according to claim 6, **characterised in that** the further reactive gas or reactive gas mixture contains hydrogen, preferably is hydrogen.

9. Method according to any of claims 1 to 8, **characterised in that** the vacuum recipient is evacuated to a pressure ($p_v$) for which:

$$10^{-11} \text{ mbar} \leq p_v \, 10^{-8} \text{ mbar}.$$

10. Method according to any of claims 1 to 9, **characterised in that** the reactive gas to be adsorbed is introduced up to a partial pressure pp for which

$$10^{-4} \text{ mbar} \leq p_p \leq 1 \text{ mbar}.$$

11. Method according to any of claims 1 to 10, **characterised in that** the gas adsorption rate on the surface is controlled by heating/cooling the surface.

12. Method according to any of claims 1 to 11, **characterised in that** the exposure is terminated **in that** the substrate is transferred from the evacuated vacuum recipient to a further evacuated vacuum recipient.

13. Method according to any of claims 1 to 12, **characterised in that** exposure of the surface is terminated by pumping out the remaining adsorbed reactive gas from the evacuated vacuum recipient.

14. Method according to claim 13, **characterised in that** the reactive gas is pumped out until a pressure $p_v'$ is reached for which:

$$10^{-11} \text{ mbar} \leq p_v' \leq 10^{-8} \text{ mbar}.$$

15. Method according to claims 1 to 14, **characterised in that** the substrate is exposed to the plasma treatment at least during a predetermined minimum time period.

16. Method according to any of claims 1 to 15, **characterised in that** at least the steps b) to $d_2$) are performed at least twice.

17. Method according to any of claims 1 to 16, **characterised in that** after carrying out at least one step $d_2$) a different material is applied to the surface.

18. Method according to claim 17, **characterised in that** the further material is applied by means of a vacuum coating process, wet chemically or galvanically.

19. Method according to any of claims 1 to 18, **characterised in that** before exposing the surface to the reactive gas to be adsorbed, the surface is exposed to a low-energetic inert gas plasma, preferably argon plasma, with ion energy $E_{II}$ at the surface of

$$0 \text{ eV} < E_{I1} \leq 20 \text{ eV}$$

preferably

$$0 \text{ eV} < E_{I1} \leq 15 \text{ eV}$$

and electron energy $E_{el}$ of

$$0\ eV < E_{e1} \leq 100\ eV.$$

20. Method according to any of claims 1 to 19, **characterised in that** before the exposure of the surface to the reactive gas to be adsorbed, the surface is exposed to a low-energetic plasma discharge in an atomic atmosphere comprising a further reactive gas, where for the ion energy $E_{I2}$ at the substrate surface:

$$0\ eV < E_{I2} \leq 20\ eV$$

preferably

$$0\ eV < E_{I2} \leq 15\ eV$$

with electron energy $E_{e2}$ of

$$0\ eV < E_{I2} \leq 100\ eV.$$

21. Method according to claim 20, **characterised in that** the further reactive gas is at least one of the gases hydrogen, nitrogen, oxygen.

22. Method according to claim 20, **characterised in that** the further reactive gas contains hydrogen, preferably is hydrogen.

23. Method according to any of claims 1 to 22, **characterised in that** after the reaction of the adsorbed reactive gas, the surface is exposed to a low-energetic inert gas plasma, preferably argon plasma, with an ion energy $E_{I3}$ at the surface of

$$0\ ev < E_{I3} \leq 20\ eV$$

preferably

$$0\ eV < E_{I3} \leq 15\ eV$$

and electron energy $E_{e3}$ of

$$0\ eV < E_{e3} \leq 100\ eV.$$

24. Method according to any of claims 1 to 23, **characterised in that** after the reaction of the adsorbed reactive gas, the surface is exposed to a low-energetic plasma discharge in an atmosphere containing a further reactive gas, where for the ion energy

$E_{I4}$ at the substrate surface:

$$0\ eV < E_{I4} \leq 20\ eV$$

preferably

$$0\ eV < E_{I4} \leq 15\ eV$$

with electron energy $E_{e4}$ of

$$0\ eV < E_{e4} \leq 100\ eV.$$

25. Method according to claim 24, **characterised in that** the further reactive gas is at least one of the gases hydrogen, nitrogen, oxygen.

26. Method according to claim 24, **characterised in that** the further reactive gas contains hydrogen, preferably is hydrogen.

27. Method according to any of claims 1 to 26, **characterised in that** the providing of the surface with material is performed with at least one of the following materials:

oxides or nitrides or oxinitrides of Si, Ge, Ti, Ta, Hf, Zr, Al, Nb, W and/or one of the following metals:

Al, Ti, Cu, W, Ta.

28. Method according to claim 27, **characterised in that** the providing of the surface with material is performed with at least one of the following materials:

silicon oxide, tantalum oxide, zirconium oxide, titanium nitride, tantalum nitride, tungsten nitride, $(TaSi)_xNy$.

29. Method according to any of claims 1 to 26, **characterised in that** all method steps are carried out in one vacuum recipient.

30. Method according to any of claims 1 to 26, **characterised in that** the method steps are carried out in at least two vacuum recipients.

31. Method according to any of claims 1 to 30, **characterised in that** the process atmosphere encompassing the substrate surface during at least one of the phases comprising steps b) and c) and/or d) to $d_2$) is separated from the inner wall of a vacuum recipient lying to the surrounding environment.

32. Method according to any of claims 1 to 31, **charac-**

**terised in that** the surface to be provided with material comprises the surface of a substrate already provided with material or coated.

33. Method according to any of claims 1 to 32, **characterised in that** before the adsorption step and/or after the reaction of the adsorbed reactive gas or reactive gas mixture, the surface is exposed to a plasma-supported cleaning step in which reactive gas or reactive gas mixture - preferably containing hydrogen - introduced into the process chamber is activated by means of a low-energetic plasma discharge with ion energy $E_r$ at the substrate surface of

$$0 \text{ eV} < E_r \leq 20 \text{ eV}$$

preferably

$$0 \text{ eV} < E_r \leq 15 \text{ eV}$$

with electron energy $E_{er}$ of

$$0 \text{ eV} < E_{er} \leq 100 \text{ eV}.$$

34. Method according to claim 33, **characterised in that** during the at least one cleaning step the cleaning process atmosphere is separated by means of a metallic encapsulation from the inner wall of the cleaning vacuum recipient exposed to the environment or - and this preferably - this process atmosphere is directly delimited by the inner wall of a cleaning vacuum recipient exposed to the environment.

35. Method according to any of claims 1 to 34, **characterised in that** by a single sequence of steps a) to $d_2$) an atom monolayer is applied to the surface.

36. Method according to any of claims 1 to 35, **characterised in that** by repeating steps b) to d) an epitaxial layer is grown, with a change of reactive gas a heteroepitaxial layer, without a change of reactive gas a homoepitaxial layer.

37. Method according to any of claims 1 to 36, **characterised in that** after performing a predetermined number of repeats of steps b) to d) sequentially on several substrates, the process chamber of the vacuum recipient is subjected to a plasma-supported process chamber cleaning step without an introduced substrate or with a dummy substrate, which process chamber cleaning step comprises preferably first an etching step, then a cleaning step preferably in a plasma containing hydrogen, inert gas or a mixture thereof.

38. Method according to any of claims 1 to 37, **characterised in that** before step a) and/or after step $d_2$) the substrate spatially separated from the vacuum recipient is subjected to a substrate cleaning step after being and the intervening transport of the substrate is performed under vacuum.

39. Method according to claim 38, **characterised in that** the transport under vacuum takes place at least in sections linearly or preferably along a circular path with linear feed movements to said recipients, preferably with movement components radial in relation a circular path.

40. Method according to any of claims 1 to 39, **characterised in that** during steps b) to and including d) the process atmosphere to which the surface is exposed is separated from the inner wall of a vacuum recipient exposed to the environment by means of a surface that in the new condition is chemically inert against the reactive gas or reactive gas mixture to be adsorbed and/or against a second plasma-activated reactive gas or reactive gas mixture, preferably by means of a dielectric or graphitic surface.

41. Method according to claim 40, **characterised in that** the inert surface is the surface of a partition wall which is spaced from the inner wall of the vacuum recipient along predominantly flat sections.

42. Method according to at least one of claims 40 or 41, **characterised in that** the surface for separation in the new condition is made from at least one of the following materials: quartz, graphite, silicon carbide, silicon nitride, aluminium oxide, titanium oxide, tantalum oxide, niobium oxide, zirconium oxide or a layered combination of these materials, in this case also with diamond-like carbon or diamond.

43. Method according to any of claims 1 to 42, **characterised in that** the plasma discharge is performed with an electron source with electron energy $E_e \leq 50 \text{ eV}$, in particular preferably by means of a DC discharge.

44. Method according to any of claims 1 to 43, **characterised in that** the plasma discharge is performed by means of a thermionic cathode, preferably with a directly heated thermionic cathode.

45. Method according to any of claims 1 to 44, **characterised in that** in the process chamber of the vacuum recipient for the plasma discharge are provided at least two spatially offset anodes, preferably each heatable, preferably each electrically actuatable separately, and by control of their applied electric potential and/or their temperature the plasma density distribution along the surface is adjusted or controlled dynamically or statically.

**46.** Method according to any of claims 1 to 45, **characterised in that** during step d), a magnetic field is generated in the process chamber and by means of this magnetic field the plasma density distribution along the surface is adjusted or controlled stationarily and/or dynamically, preferably at least wobbling locally.

**47.** Method according to any of claims 1 to 46, **characterised in that** at least the reactive gas or reactive gas mixture to be adsorbed is introduced distributed into the process atmosphere, preferably with an inlet direction substantially parallel to the surface and further preferably with injection points equidistant from the surface.

**48.** Method according to any of claims 1 to 47, **characterised in that** the substrate is a silicon-oxide -coated substrate with notches let into the silicon oxide layer, and that after n performances of one of the steps $d_2$) copper is deposited in the notches, where $n \geq 1$.

**49.** Use of the process according to any of claims 1 - 48 for manufacturing relaxed buffers.

**Revendications**

**1.** Procédé pour fabriquer des substrats approvisionnés de matière sur ses surfaces, selon lequel :

a) au moins un substrat est introduit dans un récipient à vide évacué ;
b) la surface du substrat à approvisionner avec de la matière est exposée à un gaz réactif qui est adsorbé sur la surface ;
c) l'exposition de la surface au gaz réactif est terminée ;
d) le gaz réactif adsorbé sur la surface est soumis à une réaction, **caractérisé en ce que**

$d_1$) la surface avec le gaz adsorbé est soumise à une décharge de plasma à faible énergie avec sur la surface du substrat une énergie ionique $E_{I0}$ :

$$0 \text{ eV} < E_{I0} \leq 20 \text{ eV}$$

et une énergie électronique $E_{eo}$

$$0 \text{ eV} < E_{eo} \leq 100 \text{ eV} ;$$

$d_2$) le gaz réactif adsorbé est soumis à une réaction au moins avec l'aide d'ions et d'électrons générés par plasma.

**2.** Procédé selon la revendication 1, **caractérisé en ce que** la décharge de plasma est réalisée sur la surface du substrat avec une énergie ionique $E_{I0}$ :

$$0 \text{ eV} < E_{I0} \leq 15 \text{ eV}.$$

**3.** Procédé selon la revendication 1 ou 2, **caractérisé en ce que** le gaz réactif adsorbé est un mélange de gaz réactifs.

**4.** Procédé selon l'une des revendications 1 à 3, **caractérisé en ce que** la décharge de plasma est entretenue dans une atmosphère de gaz rare.

**5.** Procédé selon la revendication 4, **caractérisé en ce que** la décharge de plasma est entretenue dans une atmosphère d'argon.

**6.** Procédé selon l'une des revendications 1 à 5, **caractérisé en ce que** la décharge de plasma est générée dans une atmosphère qui contient un gaz réactif ou un mélange de gaz réactifs supplémentaire.

**7.** Procédé selon la revendication 6, **caractérisé en ce que** le gaz réactif ou le mélange de gaz réactifs supplémentaire contient l'un au moins des gaz constitués par l'hydrogène, l'azote, l'oxygène.

**8.** Procédé selon la revendication 6, **caractérisé en ce que** le gaz réactif ou le mélange de gaz réactifs supplémentaire contient de l'hydrogène, et est constitué de préférence par l'hydrogène.

**9.** Procédé selon l'une des revendications 1 à 8, **caractérisé en ce qu'**on évacue le récipient à vide jusqu'à une pression ($p_v$) :

$$10^{-11} \text{ mbar} \leq p_v \leq 10^{-8} \text{ mbar}.$$

**10.** Procédé selon l'une des revendications 1 à 9, **caractérisé en ce qu'**on fait entrer le gaz réactif à adsorber jusqu'à une pression partielle $p_p$ :

$$10^{-4} \text{ mbar} \leq p_p \leq 1 \text{ mbar}.$$

**11.** Procédé selon l'une des revendications 1 à 10, **caractérisé en ce que** le taux d'adsorption de gaz sur la surface est commandé grâce au chauffage/refroidissement de celle-ci.

**12.** Procédé selon l'une des revendications 1 à 11, **ca-**

ractérisé en ce qu'on termine l'exposition en faisant sortir le substrat du récipient à vide évacué, pour l'amener dans un autre récipient à vide évacué.

13. Procédé selon l'une des revendications 1 à 12, **caractérisé en ce qu'**on termine l'exposition de la surface en faisant sortir par pompage du récipient à vide évacué le gaz réactif adsorbé restant.

14. Procédé selon la revendication 13, **caractérisé en ce qu'**on fait sortir par pompage le gaz réactif jusqu'à ce qu'on atteigne une pression $p_v'$ :

$$10^{-11} \text{ mbar} \leq P_v' \leq 10^{-8} \text{ mbar}.$$

15. Procédé selon les revendications 1 à 14, **caractérisé en ce qu'**on soumet le substrat au traitement au plasma au moins pendant un laps de temps minimal prédéfini.

16. Procédé selon l'une des revendications 1 à 15, **caractérisé en ce qu'**on exécute au moins les étapes b) à $d_2$) au moins deux fois.

17. Procédé selon l'une des revendications 1 à 16, **caractérisé en ce que**, après avoir exécuté au moins une étape $d_2$), on applique sur la surface une matière modifiée.

18. Procédé selon la revendication 17, **caractérisé en ce qu'**on applique la matière supplémentaire à l'aide d'un processus d'application de revêtement sous vide, par voie chimique humide ou galvanique.

19. Procédé selon l'une des revendications 1 à 18, **caractérisé en ce que**, avant d'exposer la surface au gaz réactif à adsorber, on expose la surface à un plasma de gaz rare à faible énergie, de préférence un plasma d'argon, avec sur ladite surface des énergies ioniques $E_{I1}$ :

$$0 \text{ eV} < E_{I1} \leq 20 \text{ eV},$$

de préférence

$$0 \text{ eV} < E_{I1} \leq 15 \text{ eV},$$

et une énergie électronique $E_{e1}$

$$0 \text{ eV} < E_{e1} \leq 100 \text{ eV}.$$

20. Procédé selon l'une des revendications 1 à 19, **caractérisé en ce que**, avant d'exposer la surface au gaz réactif à adsorber, on expose la surface à une décharge de plasma à faible énergie dans une atmosphère atomique qui contient un gaz réactif supplémentaire, étant précisé que pour l'énergie ionique $E_{I2}$ sur la surface du substrat, on a :

$$0 \text{ eV} < E_{I2} \leq 20 \text{ eV},$$

de préférence

$$0 \text{ eV} < E_{I2} \leq 15 \text{ eV},$$

et pour l'énergie électronique $E_{e2}$ :

$$0 \text{ eV} < E_{e2} \leq 100 \text{ eV}.$$

21. Procédé selon la revendication 20, **caractérisé en ce que** le gaz réactif supplémentaire est l'un au moins des gaz constitués par l'hydrogène, l'azote, l'oxygène.

22. Procédé selon la revendication 20, **caractérisé en ce que** le gaz réactif supplémentaire contient de l'hydrogène, et est de préférence constitué par l'hydrogène.

23. Procédé selon l'une des revendications 1 à 22, **caractérisé en ce que**, après la réaction du gaz réactif adsorbé, on expose la surface à un plasma de gaz rare à faible énergie, de préférence à un plasma d'argon, avec sur la surface une énergie ionique $E_{I3}$ :

$$0 \text{ eV} < E_{I3} \leq 20 \text{ eV},$$

de préférence

$$0 \text{ eV} < E_{I3} \leq 15 \text{ eV},$$

et pour l'énergie électronique $E_{e3}$ :

$$0 \text{ eV} < E_{e3} \leq 100 \text{ eV}.$$

24. Procédé selon l'une des revendications 1 à 23, **caractérisé en ce que**, après la réaction du gaz réactif adsorbé, on expose la surface à une décharge de plasma à faible énergie dans une atmosphère qui contient un gaz réactif supplémentaire, étant précisé que pour l'énergie ionique $E_{I4}$ sur la surface du substrat, on a :

$$0\ eV < E_{I4} \le 20\ eV,$$

de préférence

$$0\ eV < E_{I4} \le 15\ eV,$$

et pour l'énergie électronique $E_{e4}$ :

$$0\ eV < E_{e4} \le 100\ eV.$$

**25.** Procédé selon la revendication 24, **caractérisé en ce que** le gaz réactif supplémentaire est l'un au moins des gaz constitués par l'hydrogène, l'azote, l'oxygène.

**26.** Procédé selon la revendication 24, **caractérisé en ce que** le gaz réactif supplémentaire contient de l'hydrogène, et est de préférence constitué par l'hydrogène.

**27.** Procédé selon l'une des revendications 1 à 26, **caractérisé en ce que** l' approvisionnement de la surface avec de la matière se fait à l'aide de l'une au moins des matières suivantes :

    oxydes ou nitrures ou oxynitrures de Si, Ge, Ti, Ta, Hf, Zr, Al, Nb, W et/ou des métaux suivants :

    Al, Ti, Cu, W, Ta.

**28.** Procédé selon la revendication 27, **caractérisé en ce que** le l'approvisionnement de la surface avec de la matière se fait à l'aide de l'une au moins des matières suivantes :

    oxyde de silicium, oxyde de tantale, oxyde de zirconium, nitrure de titane, nitrure de tantale, nitrure de tungstène, $(TaSi)_x Ny$.

**29.** Procédé selon l'une des revendications 1 à 26, **caractérisé en ce que** toutes les étapes du procédé sont exécutées dans un récipient à vide.

**30.** Procédé selon l'une des revendications 1 à 26, **caractérisé en ce que** les étapes du procédé sont exécutées dans au moins deux récipients à vide.

**31.** Procédé selon l'une des revendications 1 à 30, **caractérisé en ce que** pendant l'une au moins des phases constituées par les étapes b) et c) et/ou d) à $d_2$, l'atmosphère de traitement qui entoure la surface du substrat est séparée de la paroi intérieure d'un récipient à vide exposée à l'environnement.

**32.** Procédé selon l'une des revendications 1 à 31, **ca-**

**ractérisé en ce que** la surface à approvisionner avec de la matière comprend la surface d'un substrat déjà approvisionnée avec de la matière ou revêtu.

**33.** Procédé selon l'une des revendications 1 à 32, **caractérisé en ce que** la surface, avant l'étape d'adsorption et/ou après la réaction du gaz réactif ou du mélange de gaz réactifs, est soumise à une étape de nettoyage avec utilisation d'un plasma lors de laquelle un gaz réactif ou un mélange de gaz réactifs introduit dans un espace de traitement - et contenant de préférence de l'hydrogène - est activé à l'aide d'une décharge de plasma à faible énergie avec sur la surface du substrat une énergie ionique $E_r$ :

$$0\ eV < E_r \le 20\ eV,$$

de préférence

$$0\ eV < E_r \le 15\ eV,$$

et pour l'énergie électronique $E_{e2}$

$$0\ eV < E_e \le 100\ eV.$$

**34.** Procédé selon la revendication 33, **caractérisé en ce que** pendant l'étape ou les étapes de nettoyage, l'atmosphère de traitement de nettoyage est séparée à l'aide d'un blindage métallique de la paroi intérieure du récipient à vide de nettoyage qui est exposé à l'environnement, ou - de préférence - cette atmosphère de traitement est délimitée directement par la paroi intérieure d'un récipient à vide de nettoyage qui est exposé à l'environnement.

**35.** Procédé selon l'une des revendications 1 à 34, **caractérisé en ce que** grâce à une seule succession des étapes a) à $d_2$), on applique une monocouche atomique sur la surface.

**36.** Procédé selon l'une des revendications 1 à 35, **caractérisé en ce qu'**en répétant les étapes b) à d), on dépose une couche épitaxiale, par hétéroépitaxie avec un changement de gaz réactif, et par homoépitaxie sans changement de gaz réactif.

**37.** Procédé selon l'une des revendications 1 à 36, **caractérisé en ce que**, après l'exécution d'un nombre prédéfini de cycles des étapes b) à d), on soumet successivement sur plusieurs substrats l'espace de traitement du récipient à vide à une étape de nettoyage d'espace de traitement avec utilisation d'un plasma, sans substrat introduit ou avec un faux substrat, laquelle étape de nettoyage d'espace de traitement comprend tout d'abord, de préférence, une étape de corrosion, puis une étape de nettoyage, de préférence dans un plasma contenant de l'hydrogène, un gaz rare ou un mélange des deux.

38. Procédé selon l'une des revendications 1 à 37, **caractérisé en ce que**, avant l'étape a) et/ou après l'étape d$_2$), on soumet le substrat, séparé dans l'espace du récipient à vide, à une étape de nettoyage de substrat et on procède au transport du substrat entre les deux sous vide.

39. Procédé selon la revendication 38, **caractérisé en ce que** le transport sous vide se fait au moins en partie linéairement ou, et de préférence, le long d'une trajectoire circulaire, avec des mouvements d'amenée linéaires vers les récipients mentionnés, de préférence avec une composante de mouvement radiale par rapport à la trajectoire circulaire.

40. Procédé selon l'une des revendications 1 à 39, **caractérisé en ce que** pendant les étapes b) à d) incluse, on sépare l'atmosphère de traitement à laquelle la surface est exposé de la paroi intérieure d'un récipient à vide exposé à l'environnement, à l'aide d'une surface inerte chimiquement à l'état neuf par rapport au gaz réactif ou au mélange de gaz réactifs à adsorber et/ou par rapport à un second gaz réactif ou mélange de gaz réactifs activé par plasma, de préférence à l'aide d'une surface diélectrique ou graphitique.

41. Procédé selon la revendication 40, **caractérisé en ce que** la surface inerte est constituée par la surface d'une cloison qui, le long de grandes sections de surface, est espacée de la paroi intérieure du récipient à vide.

42. Procédé selon l'une au moins des revendications 40 ou 41, **caractérisé en ce que** la surface prévue pour la séparation à l'état neuf est réalisée à partir de l'une au moins des matières suivantes :

quartz, graphite, carbure de silicium, nitrure de silicium, oxyde d'aluminium, oxyde de titane, oxyde de tantale, oxyde de niobium, oxyde de zirconium, ou d'une combinaison stratifiée de ces matières, avec en plus, dans ce cas, du carbone diamantaire ou du diamant.

43. Procédé selon l'une des revendications 1 à 42, **caractérisé en ce qu'**on réalise la décharge de plasma avec une source d'électrons avec une énergie d'électrons $E_e \leq 50$ eV, en particulier et de préférence à l'aide d'une décharge de courant continu.

44. Procédé selon l'une des revendications 1 à 43, **caractérisé en ce qu'**on réalise la décharge de plasma à l'aide d'une cathode thermoïonique, de préférence avec une cathode thermoïonique chauffée directement.

45. Procédé selon l'une des revendications 1 à 44, **caractérisé en ce qu'**on prévoit dans l'espace de traitement du récipient à vide, pour la décharge de plasma, au moins deux anodes décalées dans l'espace et de préférence aptes à être chauffées, de préférence à actionnement électrique séparé, et grâce à la commande des potentiels électriques appliquées sur chacune d'elles et/ou de leur température, on règle ou on commande la répartition de densité de plasma pour qu'elle soit dynamique ou statique le long de la surface.

46. Procédé selon l'une des revendications 1 à 45, **caractérisé en ce que** pendant l'étape d), on génère dans l'espace de traitement un champ magnétique et à l'aide de ce champ magnétique, on règle ou on commande la répartition de densité de plasma pour qu'elle soit stationnaire et/ou dynamique le long de la surface, de préférence avec une vobulation au moins locale.

47. Procédé selon l'une des revendications 1 à 46, **caractérisé en ce que** le gaz réactif ou le mélange de gaz réactifs à adsorber, au moins, est introduit dans l'atmosphère de traitement en étant réparti, de préférence avec un sens d'écoulement sensiblement parallèle à la surface et de préférence avec des points d'injection équidistants de celle-ci.

48. Procédé selon l'une des revendications 1 à 47, **caractérisé en ce que** le substrat est un substrat recouvert d'oxyde de silicium, avec des encoches réalisées dans la couche d'oxyde de silicium, et **en ce qu'**après la n-ième exécution de l'une des étapes d$_2$), du cuivre est déposé dans les encoches, avec n≥1.

49. Utilisation du procédé selon l'une des revendications 1 à 48 pour fabriquer des circuits tampons relaxés.

FIG.1

FIG. 2

Typ II

FIG.3

Typ II

FIG.4

FIG.5

FIG.6

FIG.7

FIG.9

R
Typ II

Ph₂
Typ I

Ph₂
Typ I

Typ I
Ph₁₂

Typ I
Ph₁₁

Typ II
R

158

156

154

152

150

EP 1 412 552 B1